# EUROPÄISCHE PATENTSCHRIFT

(11) **EP 1 314 994 B1**
(45) Veröffentlichungstag und Bekanntmachung des Hinweises auf die Patenterteilung: **05.03.2008**
(21) Anmeldenummer: 02025787.9
(22) Anmeldetag: 16.11.2002
(51) Int. Cl.: G01R 33/34

(54) **Stabilisierung der transversalen Magnetisierung bei supraleitenden NMR-Resonatoren**
Stabilisation of transverse magnetisation of superconducting NMR resonators
Stabilisation de l'aimantation transversale de résonateurs RMN supraconducteurs

(30) Priorität: 27.11.2001 DE 10157972
(43) Veröffentlichungstag der Anmeldung: 28.05.2003
(73) Patentinhaber: Bruker BioSpin AG, 8117 Fällanden (CH)
(72) Erfinder: Marek, Daniel, 5103 Möriken (CH)
(74) Vertreter: Kohler Schmid Möbus

(56) Entgegenhaltungen:
- WO-A-99/24821
- WO-A-99/24845
- DE-A- 19 733 574
- US-B1- 6 201 392

## Beschreibung

Die Erfindung betrifft ein Kernspinresonanz (=NMR)-Spektrometer mit einer Magnetanordnung zur Erzeugung eines homogenen statischen Magnetfeldes B₀ in Richtung einer z-Achse, sowie mit einem Hochfrequenz (=HF)-Resonator zum Empfang von NMR-Signalen aus einem Messvolumen, der eine oder mehrere supraleitende Komponenten enthält.

Eine solche Anordnung ist aus der US-A 5,619,140 (Referenz [1]) bekannt.

NMR ist eine sehr aussagekräftige und genaue Methode zur Strukturanalyse chemischer Verbindungen, sie ist jedoch leider nicht sehr empfindlich. Es ist deshalb ein vordergründiges Anliegen der NMR, dass Resonatoren bereitgestellt werden, die eine möglichst hohe Empfangs-Empfindlichkeit, d.h. ein möglichst hohes S/N-Verhältnis besitzen.

Dank der Verwendung von gekühlten und insbesondere supraleitenden HF-Resonatoren, ist es möglich, die Verluste im Resonator sehr klein zu halten, und damit die Empfindlichkeit wesentlich zu steigern. Als Supraleiter eignet sich gegenwärtig Hochtemperatur-Supraleiter (= HTS)-Material am besten. Dieser besitzt eine hohe Sprungtemperatur und ist, verglichen mit anderen Supraleitern, sehr unempfindlich gegenüber statischen magnetischen Feldern.

Die zu messende Substanz ist meistens flüssig und in einem Messröhrchen eingeschlossen, das sich normalerweise auf Raumtemperatur befindet und durch ein Zwischenrohr und einer Vakuumkammer vom kalten NMR-Resonator, der sich bei ca. 20K befindet, getrennt ist.

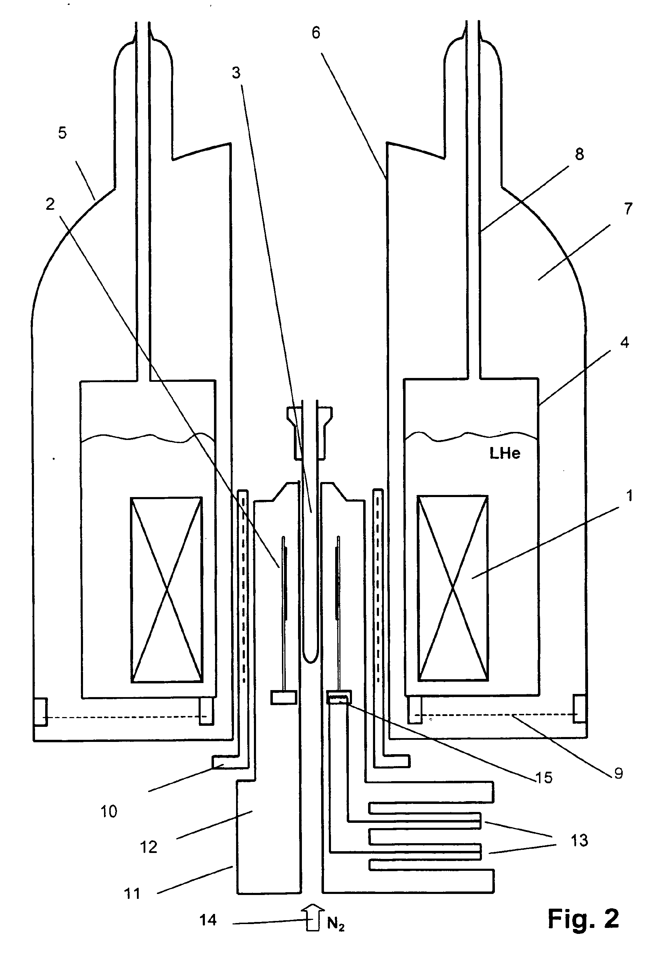

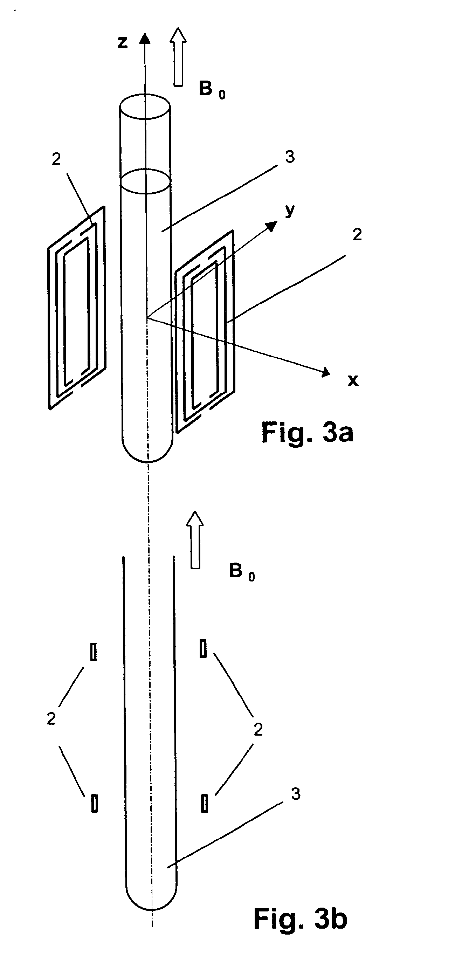

Anordnungen mit gekühlten supraleitenden HF-Spulen sind beispielsweise beschrieben in [1] oder [7]. Ein Querschnitt durch den NMR Magneten, mit Shimsystem und Kryo-Probenkopf mit gekühlter supraleitender HF-Spule (Resonator) ist schematisch in Fig. 2 dargestellt. Eine solche HF-Spulenanordnung ist in den Figuren 3a,b prinzipiell dargestellt, in Fig. 3a perspektivisch und in Fig. 3b als Schnitt in der xz-Ebene.

Das wesentliche Problem der Verwendung von Supraleitern bei Empfangssystemen (HF-Empfangsspule) von NMR ist ihre statische Magnetisierung. Diese kann, wenn sie nicht kontrolliert wird, so große Feldstörungen innerhalb der Probe verursachen, dass die Linienbreite unbrauchbar groß wird. Es wurde eine Anzahl von Verfahren publiziert, um diese unerwünschte Magnetisierung zu minimieren [2], [3], oder es wenigstens zu versuchen [4].

Diese beschriebenen Verfahren weisen jedoch schwerwiegende Nachteile auf, wie weiter unten erörtert wird. Insbesondere bewirken auch bei einer störungsfreien Spule später ungewollt angewandte transversale Magnetfelder eine erneute Erzeugung von wesentlichen Störfeldern.

Ein Ziel der vorliegenden Erfindung ist es daher, bei den HF-Spulen nach [1] gar keine störende Magnetisierung aufkommen zu lassen. Werden bei diesen Spulen die Verfahren nach [2], [3] angewendet, so kann zwar ihre Magnetisierung im wesentlichen eliminiert werden. Das große Problem kommt jedoch im nachfolgenden Betrieb, denn durch eine ungewollte, mechanische Verkippung der Spulen gegenüber dem Magnet können diese Spulen wiederum magnetisiert werden. Die vorliegende Erfindung soll gleichzeitig auch ermöglichen, dass eine einmal entmagnetisierte Spule beim gesamten weiteren Betrieb stets entmagnetisiert bleibt.

Gemäß dem Stand der Technik gibt es neben den Spulentypen [1] eine weitere Klasse von supraleitenden HF-Spulen, wie sie in [5] und [6] beschrieben sind. Diese sind prinzipbedingt bereits sehr unempfindlich auf allfällige störende transversale Felder.

Die guten Wirkungen der erfindungsgemäßen Vorrichtung sind jedoch auch mit diesen Spulentypen ([5], [6]) kompatibel und sogar kumulativ, d.h. durch die vorliegende Erfindung können auch die verbleibenden, bereits sehr kleinen Störungen dieser Spulentypen nochmals um einen weiteren wesentlichen Faktor reduziert werden.

Es wird auch der Anwendungsbereich gewisser Konfigurationen dieser Spulen erweitert. Durch diese Kombination werden extrem störungsfreie und langzeitstabile supraleitende HF-Spulenanordnungen realisierbar, die den allerhöchsten Ansprüchen im Hinblick auf Störungsfreiheit und Stabilität entsprechen, die den Stand der Technik bei weitem übertreffen und dadurch neue Anwendungsgebiete erschließen können.

Wie in [2] und [6] ausführlich dargestellt wird, ergibt sich eine globale Magnetisierung eines Supraleiters vom Typ II durch eingeprägte Ströme, die innerhalb des Supraleiters in geschlossenen Bahnen fließen. Diese werden durch die Vorgeschichte des Supraleiters bestimmt und bleiben, sobald sich die äußeren Verhältnisse nicht ändern, wegen des Null-Widerstandes des Supraleiters, für praktisch unbeschränkte Zeiten bestehen.

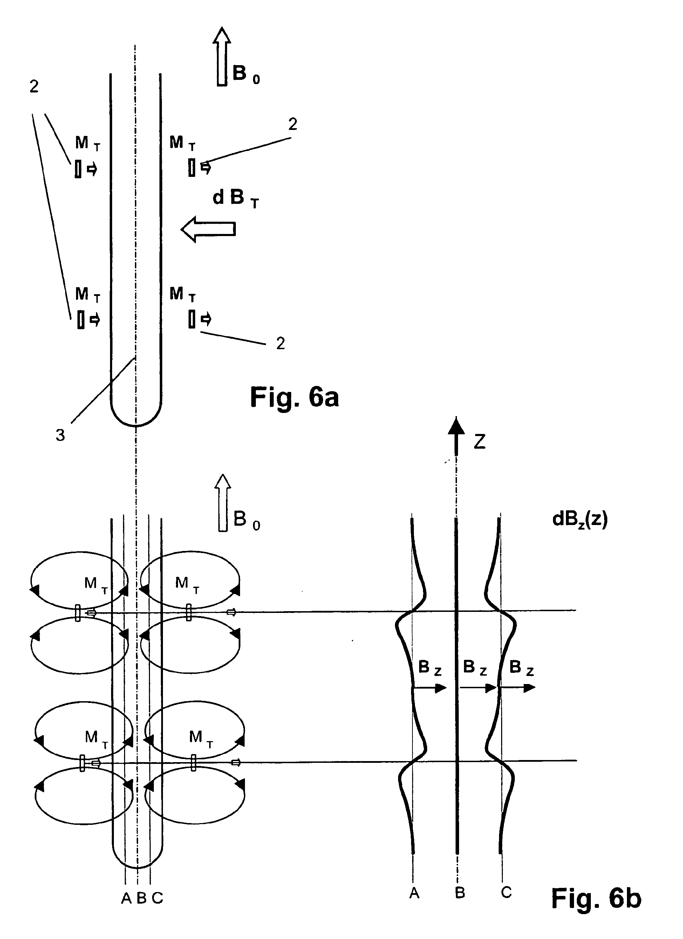

Bei den gemäß dem Stand der Technik eingesetzten Dünnschicht-Spulen (z.B. [1], oder Figuren 3a,b) ist diese Magnetisierung vor allem in der Richtung senkrecht zum Substrat von dominanter Bedeutung, da die Fläche, in der der Strom fließt, am größten ist. Diese transversale Magnetisierung M_{T} (in Fig. 6a) hat wesentlich größere Auswirkungen als die longitudinale (in z-Richtung), denn bei der longitudinalen ist die verfügbare Fläche, die zusammen mit dem Kreisstrom ein Dipolmoment erzeugt, durch die extreme Dünne der Schicht sehr klein.

Auf jeden Fall erzeugt eine Magnetisierung dann jeweils außerhalb des Supraleiters ein zusätzliches Magnetfeld, das starke unerwünschte Feldstörungen im Probenvolumen hervorrufen kann. In Fig. 6b ist die Auswirkung der transversalen Magnetisierung auf die Feldstörungen außerhalb der HF-Spule, und insbesondere auf die B_{z} Komponenten im Inneren der NMR Probe schematisch dargestellt.

Es gilt nun, die transversale Magnetisierung M_{T}, die sich im Betrieb sehr störend auswirken kann, zu minimieren.

### Begriffe:

Im Nachfolgenden ist viel von SL-Spulen die Rede, die gegenüber dem statischen Feld B₀ des Magneten verkippt werden. Darum ist eine genaue Definition der Begriffe und insbesondere des verwendeten Koordinatensystems vonnöten.

Wir verstehen unter dem Begriff **"transversale Magnetfeldänderung"** eine zusätzliche Magnetfeldkomponente_dB_{T} im Koordinatensystem der supraleitenden Spule, die senkrecht ist zur Richtung des bis zu dieser Änderung bestehenden statischen Magnetfeldes B₀. Dies entspricht auch, im Koordinatensystems der SL Spule, in erster Ordnung einer Drehung des statischen Magnetfeldes gegenüber der SL Spule, was auch gleichbedeutend ist mit einer Drehung der Spule bezüglich dem statischen Magnetfeld.

Bei den hier vorwiegend betrachteten flächigen, im wesentlichen parallel zum Magnetfeld orientierten, supraleitenden Strukturen führt dies zu einer Magnetisierung des Supraleiters in der Richtung senkrecht zur Supraleiterfläche aus.
Diese nennen wir dann **"transversale Magnetisierung**". Diese Magnetisierung M_{T} ist dann in erster Ordnung senkrecht zum statischen Feld B₀ gerichtet.

Der bisherige Ansatz zur Minimierung von Störungen in den Spektren durch Inhomogenitäten des statischen Magnetfeldes bestand aus den folgenden Strategien:
1. Minimierung der maximal möglichen Größe der Magnetisierung (durch Unterteilung der Spule in hinreichend schmale Streifen [1], [5]).
2. Der Versuch, die verbleibende mögliche Magnetisierung erst gar nicht entstehen zu lassen durch langsame Abkühlung des Supraleiters im Feld [4].
3. Durch Nachbehandlung der supraleitenden Spule mit einer Sequenz abnehmender transversaler Magnetfelder sozusagen zu "Entmagnetisieren" [2], [3] (dabei wird eine Stromstruktur mit eng beieinanderliegenden entgegengesetzten Strombereichen eingeprägt, so dass die Summe der einzelnen Magnetfeldbeiträge sich in guter Näherung aufheben soll.
4. Die supraleitende Struktur der Spule so auszubilden, dass zwar Störungen im Magnetfeld zugelassen werden, das HF-aktive Gebiet aber durch normalleitende Elemente auf ein Gebiet mit nur geringen Störungen begrenzt wird [5].
5. Die supraleitende Struktur der Spule so auszubilden, dass zwar Störungen im Magnetfeld zugelassen werden, aber durch eine längliche Bauweise der Spulen mit einer HF-mäßig unterbrochenen, aber makroskopisch homogenen Verteilung des supraleitenden Materials eine in z gleichmäßige Verteilung der Magnetisierung zu bewirken. [6]. Dabei kann gezeigt werden, dass solche Spulen zwar die Bₓ und By Komponenten des Magnetfelds stark stören können, aber dass die B_{z} Komponente bis auf eine sehr geringe Welligkeit ungestört bleibt. Da nur die B_{z} Komponente NMR relevant ist, bleibt das Spektrum praktisch artefaktfrei.

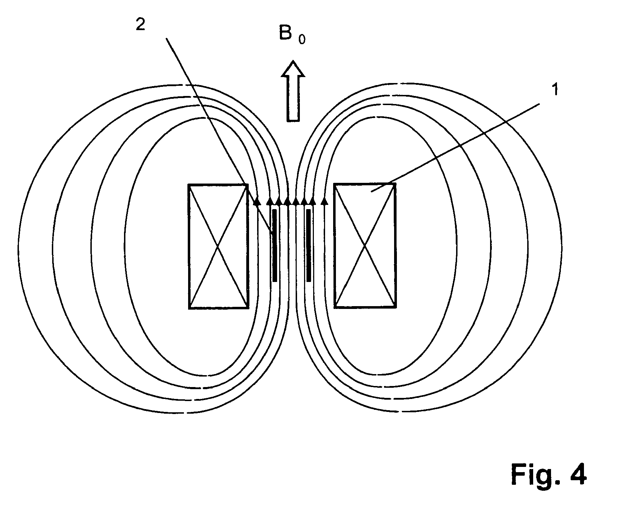

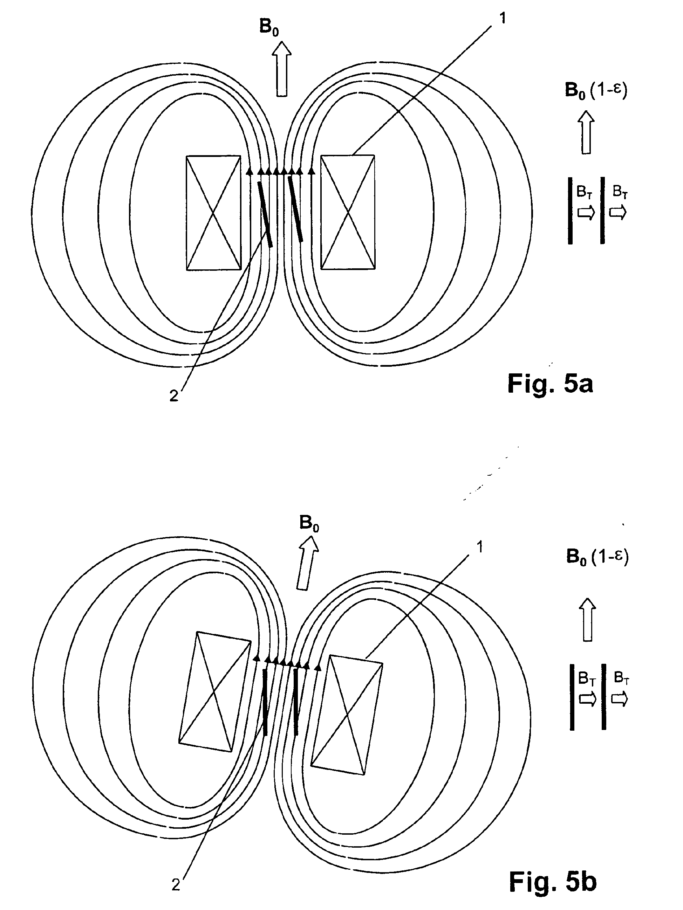

Die hier aufgeführten Methoden haben die folgenden Nachteile:
1. Die Spulen von dem in [1] beschriebenen Typ können zwar durch die Methoden [2], [3] entmagnetisiert werden. Das Problem stellt sich jedoch später im Betrieb. Bei typischen Geometrien einer HTS Spule gemäß [1], wie in den Figuren 3a,b dargestellt (Spule als Dünnschicht aus YBCO auf Saphirsubstrat, im wesentlichen parallel zum statischen Feld B₀ ausgerichtet, totale Breite der Spulenleiter einige mm, aufgeteilt in schmale Streifen mit einer Breite von 10-20 µm mit einigen µm Abstand, Schichtdicke ca. 300nm, seitlicher Abstand der Spule von der zu untersuchenden NMR Probe von einigen [typischerweise in der Größenordnung von 1-5 mm), genügen bereits geringe Änderungen dB_{T} der auf die supraleitende Schicht wirkenden transversalen Felder von der Größenordnung 1×10⁻⁴T (lG), um bei einer vorher nicht magnetisierten (oder zuvor entmagnetisierten) Spule transversale Magnetisierungen M_{T} zu erzeugen (Fig. 6a), die dann innerhalb der Probe zu signifikanten Änderungen der Protonen-Resonanzfrequenz führen.
   Eine transversale Magnetisierung des Supraleiters führt durch die räumliche Ausdehnung und Krümmung der Feldlinien zu einer Beeinflussung der NMR-relevanten B_{z} Komponente in der benachbarten Probe (Fig. 6b). Dies führt dann aber im NMR-Spektrum zu störenden Linienverbreiterungen und Linien-Verzerrungen. Dabei genügt eine extrem kleine Störung der B_{z} Komponente in der Probe von unter 1×10⁻⁷T (1mG), um große Artefakte im Spektrum zu erzeugen: Dies ist so empfindlich, denn bei Protonen entspricht eine Änderung der B_{z} Komponente um 2.34×10⁻⁸T (0.000234 G)einer Frequenzänderung von 1 Hz.
   Bei den typischen Geometrien erhalten wir in der Probe eine Störung von 0.03 - 6 Hz pro 1G transversale Feldänderung dB_{T} im Bereich der Spule, wobei der Koeffizient und die genaue Form der Störung von den genauen Geometrieverhältnissen abhängen. Die dazu nötige Erzeugung einer Änderung der Transversalkomponente von dB_{T} = 1G entspricht bei einem Magneten mit einem B₀ von 10T einer Verkippung der HF-Spule gegenüber dem Magneten von ca. 0.00057 Grad. Dies entspricht einer extrem kleinen Verkippung von 10 µm/m (10 Mikrometer auf 1 Meter) (→5×10⁻⁴T-0.1T (5-1000G) pro 0.1 Grad Verkippung)
2. Die transversalen Felder in der oben aufgeführten Größenordnung wirken sich bereits negativ auf das Spektrum aus, sind aber i.A. reversibel, d.h. beim Verschwinden des transversalen Feldes verschwinden auch die Störungen. Bei transversalen Feldern von ca 2×10⁻³T (20G) und darüber wird die Magnetisierung des Supraleiters jedoch irreversibel verändert, da Abschirmströme gebildet werden, die in einem immer größer werdenden Bereich des Supraleiters (von den Kanten ausgehend) die kritische Stromdichte des Materials überschreiten. Dies ergibt ein zunehmend hysteretisches Verhalten, das nun aber zur Folge hat, dass nach der Verkippung das statische Magnetfeld im Messvolumen irreversibel inhomogen wird.
   Dies führt dann bei den oben aufgeführten typischen Geometrien zu einer Feldstörung in der Probe von der Größenordnung von 0.6 - 120 Hz, was bei Hochauflösungsanwendungen zu völlig unbrauchbaren Spektren führt. Ein transversales Magnetfeld von 2×10⁻³T (20G) entspricht bei einem B₀ von 10T einer Verkippung von 0.011 Grad! (Dies entspricht einer Verkippung von 200 µm/m oder 2 µm/cm)
3. Eine über den Ansatz der Nichtreversibilität weitergehende Verkippung führt schließlich bei transversalen Feldern von ca 5×10⁻² T (500G)(entspricht ca. 0.28 Grad oder 5 mm/m bei 10 T) zum Erreichen der kritischen Stromdichte im gesamten supraleitenden Einzelelement und somit zu einer vollständigen Magnetisierung der supraleitenden Spulenelemente, wie in [2] beschrieben. Dies führt dann in der Probe zu Frequenzstörungen von der Größenordnung von 3-1000 Hz.
4. Es muss beachtet werden, dass es sich bei der Verkippung schlussendlich um eine Verkippung des Magnetfeldes des Magneten gegenüber den SL Spulen handelt. Ein Magnetsystem mit Feldlinien parallel zur supraleitenden Schicht der HF-Spule ist in Fig. 4 dargestellt.
   Die oben erwähnten Verkippungen können einerseits durch Bewegungen der Spulen innerhalb des Probenkopfes entstehen (Fig. 5a), aber auch durch Bewegungen des Magneten gegenüber dem Probenkopf oder Dewar (Fig. 5b).
   Wenn man die Größenordnungen der Winkel betrachtet, sieht man, dass beim Punkt 1 dies einer Verkippung von 10 µm/m entspricht und beim Punkt 2 sogar die Irreversibilität bei ca. 200 µm/m erreicht wird. Vergegenwärtigt man sich, wie weich (insbesondere seitlich) ein Kryo-Magnet im Dewar aufgehängt ist, sieht man sofort, dass die obigen Bedingungen unter normalen Umständen gar nicht eingehalten werden können!
   Dies hat zur Folge, dass in der Praxis die in [1] beschriebenen Systeme, auch wenn die weiteren Verfahren gemäß [2]-[4] zum Erfolg führen würden, nicht zufriedenstellend funktionieren können, insbesondere nicht über längere Zeiträume (man denke nur an Bewegungen des Magneten auf Schwingungsdämpfern, abnehmendes Gewicht durch Verdampfung der kryogenen Flüssigkeiten, etc...).
5. Die Spulen gemäß [5] und [6] sind gegen diese transversalen Veränderungen weitgehend immun und können darum erstmals wirklich funktionsfähige und langzeitstabile NMR Systeme ergeben. Dies wird jedoch in beiden Fällen durch erhebliche Einschränkungen in der geometrischen Freiheit und Effizienz der Ausgestaltung erkauft, die zu gewissen Verlusten in der HF-Performance führen.
6. Werden die Spulen gemäß [6] einem transversalen Magnetfeld ausgesetzt, so erzeugen sie, je nach individueller geometrischer Ausführung, eine leichte Welligkeit im B_{z} Feld, die zwar je nach Geometrie sehr klein, aber u.U. auch etwas störend sein kann. Auch ist es so, dass gewisse Ausführungsformen dieser Spulen [6] nur bis zu einem maximalen transversalen Magnetfeld funktionieren (unter der Reversibilitätsgrenze, siehe obiger Punkt 2). Darüber geht der Kompensationseffekt verloren und die Spulen haben dann wesentlich schlechtere Eigenschaften, die, je nach Verhältnis der kritischen Ströme parallel und senkrecht zum B₀ Feld und der Geometrien der Elemente, nur noch einen kleinen Vorteil gegenüber Spulen gemäß [1] aufweisen.
   Darum ist es bei dieser Unterklasse von Spulen eminent wichtig, dass sie (nach der Abkühlung unter T_{c}) nie ein zu hohes transversales Feld erfahren. Aus diesem Grunde ist es bei gewissen Unterklassen der Spulen [6] vorteilhaft, wenn das transversale Magnetfeld innerhalb gewisser, wenn auch nicht allzu enger Schranken bleibt.
   Auch die Restwelligkeit aller Spulen des Typs [6] ist proportional zur transversalen Magnetisierung. Diese wiederum kann mit dem transversalen Magnetfeld kontrolliert werden. Bleibt das Feld klein, wird auch diese transversale Magnetisierung klein und somit können die verbleibenden Reststörungen nochmals stark verkleinert werden.

Bei allen oben diskutierten Publikationen zum dem Stand der Technik nach [1]-[3] ist davon ausgegangen worden, dass sich beim Abkühlen einer supraleitenden Spule Verkippungen relativ zum Magnetfeld ergeben. Aus diesem Grunde wurden Verfahren entwickelt, um die sich daraus ergebende transversale Magnetisierung zu eliminieren. Was jedoch nachher passiert, wurde nicht diskutiert.

In [6] wurde die Problematik der Verkippungen erkannt, und es wurden neue Spulenstrukturen vorgestellt, die auf diese Verkippungen weitgehend immun sind,

Die absolute Größe der Verkippungen ist jedoch extrem klein, und so wurden sie jeweils bisher als gegeben und unvermeidlich betrachtet.

Die vorliegende Erfindung stellt sich jedoch auf den genau diametral entgegengesetzten Standpunkt und vermeidet alle oben aufgeführten Probleme, indem sie eine Vorrichtung vorstellt, die die Änderungen der transversalen Feldkomponenten von vorneherein verhindert.

Aufgabe der vorliegenden Erfindung ist es also, in einem NMR-Spektrometer der eingangs beschriebenen gattungsgemäßen Art, das HF-Spulen mit supraleitenden Komponenten enthält, erst gar keine störende transversale Magnetisierung aufkommen zu lassen.

Erfindungsgemäß wird diese Aufgabe auf ebenso verblüffend einfache wie überraschend wirkungsvolle Weise dadurch gelöst, dass eine Stabilisierungsvorrichtung vorgesehen ist, die auf die supraleitenden Komponenten des HF-Resonators wirkende Magnetfeldkomponenten B_{T} transversal zum homogenen Magnetfeld B₀ konstant hält, dass eine Detektionsvorrichtung vorgesehen ist, die die transversalen Magnetfeldkomponenten B_{T} misst, dass die Stabilisierungsvorrichtung eine aktive Kompensationsvorrichtung umfasst, der über eine Rückkopplung oder Steuerung die gemessenen transversalen Magnetfeldkomponenten B_{T} zugeführt werden, und dass die aktive

Kompensationsvorrichtung die transversalen Magnetfeldkomponenten im Bereich der supraleitenden Komponenten des HF-Resonators konstant hält.

Mit der erfindungsgemäßen Anordnung können praktisch alle aus Typ II Supraleiter bestehenden Spulen gemäß dem Stand der Technik extrem störungsarm bezüglich der durch sie erzeugten Störungen des statischen Magnetfeldes betrieben werden.

Die überraschende Wirkungsweise der Erfindung beruht im Wesentlichen auf den folgenden Punkten:

Die Verkippungen sind so extrem klein, dass es zunächst nicht ersichtlich ist, wie sie überhaupt zu kontrollieren sein sollten. Die Größenordnung liegt, wie oben erwähnt, im Bereich von ca. 10-100 µm/m oder ca. 100nm-1µm /cm.
Je nach genauer Anforderung muss also die Winkelausrichtung der supraleitenden Spulen in diesem Bereich liegen. Die obigen Werte basieren auf einem Magneten mit einem Feld von 10T. Bei höheren Feldern verschärfen sich sie Winkelanforderungen entsprechend sogar noch weiter.

Dazu kommt noch, dass diese Lagepositionierung mit der obigen Genauigkeit absolut langzeitstabil sein muss. Bedenkt man dazu, dass alle mechanischen Komponenten zum "Kriechen" neigen und elektronische Komponenten Instabilitäten und Driften aufweisen, scheint dies aussichtslos zu sein. Zudem dürfen eventuelle Vorrichtungen zur Messung des transversalen Magnetfeldes die Feldhomogenität ihrerseits nicht stören.

Diese Gründe führten wahrscheinlich historisch dazu, dass bisher keinerlei Versuche bekannt sind, das transversale Feld, das auf die supraleitenden Spulen wirkt, wirklich zu kontrollieren.

Zudem musste zuerst erkannt werden, dass eine systematische, konsistente Kontrolle überhaupt nötig ist, denn beim Problem der Ausrichtung handelt es sich nicht nur um eine Ausrichtung und Stabilität der HF-Spulen innerhalb (gegenüber) des(m) Probenkopf(es), sondern total der HF-Spulen zum Magnet hin, und dieser ist innerhalb der oben genannten Grenzen NICHT stabil zu halten. Versuche, die transversalen Feldänderungen durch einen sehr starren Aufbau des Probenkopfes und der supraleitenden Spulen alleine zu lösen, sind von vorneherein zum Scheitern verurteilt. Dies ist eine sehr wichtige Erkenntnis.

Dazu noch zwei Hintergrundbemerkungen:
a) Bei Probenköpfen, deren HF-Spule aus einem normalleitenden Metall besteht und die auch sonst keinerlei supraleitende Komponenten enthalten, ist die sich durch alle Komponenten ergebende Magnetisierung im Wesentlichen parallel zum B₀ Feld. Diese Magnetisierung ist dann proportional zum Magnetfeld, in Betrag und Richtung. Der Betrag ist extrem klein, da nur Materalien verwendet werden, die an sich schon sehr kleine Störungen verursachen und/oder aus magnetisch kompensierten Materialien bestehen (Volumen-Suszeptibilität bei Hochauflösungsanwendungen ca. 10⁻⁷ MKS). Eine kleine Störung bleibt eine kleine Störung, auch wenn sich die Orientierung gegenüber dem Magnetfeld ändert. Bei magnetisch kompensierten Anordnungen, die darauf beruhen, dass die Materialien mit gleicher Suszeptibilität in z-Richtung durchgehend sind (wie letztendlich das Probenröhrchen und die Probe selbst!), sind die Störungen, die sich beim Verkippen ergeben, quadratisch mit dem Kippwinkel, und darum bei kleinen Kippwinkeln vernachlässigbar. Darum konnten bis heute überhaupt funktionsfähige NMR-Geräte gebaut werden, bei denen der Magnet relativ weich gegenüber dem Probenkopf aufgehängt ist.
b) Supraleitende Teile reagieren aber extrem empfindlich auf Feldänderungen. Transversale Feldänderungen, die sich als Folge vom Verkippen des Magneten gegenüber dem Supraleiter ergeben, sind in erster Ordnung mit dem Verkippwinkel verknüpft. Diese transversalen Feldänderungen ergeben eine transversale Magnetisierung des Supraleiters, die wegen der differenziellen Diamagnetizität extrem stark ist (perfekter Diamagnet: Volumen-Suszeptibilität ca. -1 MKS, d.h. von der Größenordnung ca. 10⁰ MKS, dies ist also 7 Größenordnungen stärker als bei den magnetisch kompensierten Materialien). Glücklicherweise sind die sich aus der differentiellen Suszeptibilität ergebenden Magnetisierungen proportional zur Feldänderung. Dies führt also beim Abkühlen des Supraleiters im Magnetfeld u.U. zu vernachlässigbar kleinen Störungen, aber schlussendlich zu starken Änderungen von B_{z} im Probenvolumen und somit zu Störungen im NMR Spektrum bei nachfolgenden Änderungen des Magnetfeldes. Diese sind in erster Ordnung mit dem Verkippwinkel verknüpft und i.A. sehr stark.

Mit den gleichen Argumenten kann auch die longitudinale Magnetisierung behandelt werden. Bei Änderungen von B₀ ergibt sich ebenfalls eine starke Änderung der longitudinalen Magnetisierung eines Supraleiters. Dies ist aber aus den folgenden zwei Gründen in der Praxis nicht relevant:
i) Eine 1 G-Änderung im B₀ Feld entspricht bei 10T einer Änderung von 10 ppm. Dies ist aber bei Protonen die gesamte Spektrumbreite! Durch die in den modernen Spektrometern eingebauten Lock-Systeme wird das Feld aber auf eine Konstanz von ca. 10⁻¹⁰ gehalten, dies entspricht 10⁻⁵ G. Somit ändert sich das longitudinale Feld (oder der Feldbetrag) niemals in der betrachteten Größenordnung, die stören würde.
ii) Aber auch bei größeren Feldänderungen, wie sie z.B. beim Anlegen von gepulsten Feld-Gradienten auftreten können, limitieren die kritischen Ströme, zusammen mit der sehr dünnen Schicht und der sich daraus ergebenden kleinen vom induzierten Strom umflossenen Fläche, den Maximalbetrag der Magnetisierung in z-Richtung auf ein minimales Maß.

Wir sehen also, dass falls es technisch möglich sein sollte, das transversale Magnetfeld auf ca. 10⁻⁴T (1G)genau konstant zu halten, die zusätzlichen statischen Feldstörungen, herrührend von der Ummagnetisierung von supraleitenden HF-Spulen, praktisch eliminiert werden können.

Das Problem der Stabilisierung des Magnetfeldes (d.h. der transversalen Komponenten B_{T}) kann aber gelöst werden! Im Prinzip sind dazu, wie wir zeigen werden, passive und aktive Vorrichtungen geeignet.

Das erfindungsgemäße NMR-Spektrometer stellt eine sehr effektive und flexible Lösung dar, die mit vertretbarem Aufwand realisierbar ist, aber einen außerordentlich stabilen Detektor braucht, wobei der Frequenzgang nach oben beschränkt ist.

Bei einer bevorzugten Ausführungsform des erfindungsgemäßen NMR-Spektrometers umfasst die Stabilisierungsvorrichtung einen normalleitenden, vorteilhafterweise gekühlten und gegebenenfalls zusätzliche supraleitende Komponenten enthaltenden Transversalfeld-Schild, der den HF-Resonator umfänglich umgibt, mit diesem in einer bezüglich der relativen Verkippung kontrollierten Weise, insbesondere verkippungssicher starr verbunden ist und die auf den HF-Resonator wirkenden transversalen Magnetfeldkomponenten B_{T} dämpft.

Damit können die hochfrequenten Störungen auf sehr einfache Weise ausgefiltert werden. Dies kann auch schon ohne weitere Maßnahmen sehr nutzbringend angewendet werden, denn es können vibrationsbedingte Störungen, die zur Feldmodulation und zu spektralen Störungen führen, ausgefiltert werden. Unter Umständen ist dies die einzige sinnvolle Art, diese hochfrequenten Störungen zu bekämpfen, denn die weiter unten aufgeführten Kompensationsverfahren können nicht beliebig schnell reagieren. Diese Ausführungsform bietet sich geradezu auch ideal an, um die aktiven Kompensationsverfahren im Bereich der hohen Frequenzen (z.B. im Bereich über 10-100 Hz) zu ergänzen und somit insgesamt eine breitbandige Stabilisierung im gesamten Bereich 0Hz bis unendlich zu erzielen. Des weiteren bewirkt ein solcher Schild keinerlei Nachteile, auch bezüglich des Shimmens nicht, denn die Response wird nur etwas verlangsamt, aber alle Shimfunktionen bleiben erhalten.

Bei einer weiteren vorteilhaften Ausführungsform der Erfindung umfasst die Stabilisierungsvorrichtung einen flächigen oder aus diskreten drahtförmigen oder schichtförmigen Leitern bestehenden, supraleitenden Transversalfeld-Schild, der den HF-Resonator umfänglich umgibt, mit diesem in einer bezüglich der relativen Verkippung kontrollierten Weise, insbesondere verkippungssicher starr verbunden ist und die auf den HF-Resonator wirkenden transversalen Magnetfeldkomponenten B_{T} konstant hält.

Diese Art Schild kann persistente Ströme tragen. Im Prinzip ist er also geeignet, die Abschirmung auch bei beliebig tiefen Frequenzen bis zu Null aufrechtzuerhalten. Bei einer Implementation eines solchen Schildes erübrigen sich dann idealerweise sogar jegliche weitere Maßnahmen, insbesondere auch die aktiven. Es können sich allerdings Probleme mit dem Shimmen und B₀-Konrolle (Lock) ergeben. Die Anordnung weist wegen der Kühlung eine gewisse Komplexität auf und muss unabhängig von SL Spule sein, damit sie beliebig kontrollierbar ist. Fraglich, ob nach Abkühlen unter die Sprungtemperatur die Shimwerte genau genug erhalten bleiben. Außerdem ist bei dieser Ausführungsform in der Regel kein Nachshimmen möglich, aber eventuell auch gar nicht nötig.

Eine besonders vorteilhafte Weiterbildung der oben beschriebenen zeichnet sich dadurch aus, dass der Transversalfeld-Schild in z-Richtung an einem oder mehreren Stellen durch Schlitze unterbrochen ist, welche die z-Komponente des homogenen statischen Magnetfelds B₀ ungehindert durchlassen. Vorteilhafterweise funktioniert hier ein Feld-Lock, aber das Shimmen ist weiterhin ohne weitere Maßnahmen (z.B. Aufheizen über Tc beim Shimmen, oder Shimsystem innerhalb) nicht möglich.

Bevorzugt ist auch eine Ausführungsform des erfindungsgemäßen NMR-Spektrometers, bei der die Stabilisierungsvorrichtung eine Einrichtung zur Durchführung einer Drehbewegung der supraleitenden Komponenten des HF-Resonators um eine Achse, die nicht parallel zum homogenen Magnetfeld B₀ gerichtet ist, umfasst.

Mit der Drehung von supraleitenden Komponenten kann in deren Koordinatensystem auf eine sehr effektive Art ein beliebiges Transversalfeld kreiert werden. Gegenüber Feldspulen sind vorteilhafterweise sehr hohe B_{T} Komponenten problemlos möglich und es erfolgt keine Dissipation durch den bei Spulen nötigen (u.U. sehr hohen) Betriebsstrom. Das Transversalfeld ist auch extrem homogen, was bei Feldspulen gar nicht einfach zu machen ist. Ebenfalls ist eine Verkippung die exakt richtige physikalische Antwort auf Störungen, die durch eine Verkippung ihrerseits verursacht werden. Bei Dünnschichtspulen, die alle in einer Ebene oder parallel zu einer Ebene angeordnet sind, genügt eine einzige Achse, die nicht senkrecht zu dieser Ebene und nicht parallel zu B₀ ist.

Alternativ kann bei anderen Ausführungsformen die Stabilisierungsvorrichtung eine Einrichtung zur Durchführung einer Drehbewegung der supraleitenden Komponenten des HF-Resonators um zwei nicht untereinander parallele und nicht zum homogenen Magnetfeld B₀ parallele Achsen umfassen. Bei supraleitenden (=SL) Spulen, die nicht nur in einer Ebene ausgerichtet sind, müssen beide Komponenten von B_{T} kontrolliert werden. Dies geschieht mit dieser Ausführungsform der Erfindung ohne weitere Schwierigkeiten. Allerdings erfordert die Anordnung eine höhere Komplexität.

Vorteilhaft ist auch eine Ausführungsform des erfindungsgemäßen NMR-Spektrometers, bei der die Stabilisierungsvorrichtung eine oder mehrere Magnetfeldspulen umfasst, die transversale Magnetfelder im Bereich der supraleitenden Komponenten des HF-Resonators erzeugen. Damit kann ein schneller Aktuator ohne bewegliche Teile eingesetzt werden, wobei allerdings die Feldhomogenität beim Design der Spulen vorab berücksichtigt werden muss.

Bei einer Weiterbildung umfasst die Detektionsvorrichtung zur Messung der transversalen Magnetfeldkomponenten B_{T} eine oder mehrere Hall-Sonden. Diese Lösung ist sehr einfach und preiswert, allerdings können Probleme mit der Langzeitstabilität, Driften und störende Temperaturkoeffizienten auftreten. Außerdem braucht die Anordnung eine Stromversorgung, die potentiell Feldstörungen verursachen kann.

Vorzugsweise ist mindestens eine der Hall-Sonden mit einer supraleitenden Schlaufe so gekoppelt, dass diese die Empfindlichkeit der Hall-Sonde auf die zu messende transversale Magnetfeldkomponente steigert. Dies führt auch zu einer erhöhten Stabilität der Anordnung, die allerdings mit einer höheren Komplexität erkauft wird. Die Trafo-Schlaufe darf das B₀-Feld im Bereich der NMR Probe nicht stören. Möglicherweise wird auch eine Heizeinrichtung zum Setzen des Nullpunkts erforderlich. Wenn die Schlaufe aus irgendeinem Grund "quenchen" sollte, geht nämlich die Nullpunktreferenz verloren.

Bevorzugt ist auch eine Weiterbildung, bei der die Detektionsvorrichtung zur Messung der transversalen Magnetfeldkomponenten B_{T} einen oder mehrere SQUID-Sensoren umfasst, die durch eine oder mehrere supraleitende Schlaufen an das transversale Magnetfeld angekoppelt sind. Eine solche Anordnung ist extrem empfindlich, da ein SQUID Magnetfelder <<1×10⁻⁴T (1G)detektieren kann.

Besonders bevorzugt ist eine Weiterbildung, bei der die Detektionsvorrichtung zur Messung der transversalen Magnetfeldkomponenten B_{T} eine oder mehrere elektrisch leitende Pick-Up Schlaufen umfasst, die periodisch verkippt und deren induzierte Spannungen ausgewertet werden. Diese Anordnung weist eine ausreichend hohe Empfindlichkeit auf, verwendet keine "exotische" Technologie und bei korrekter Betriebsweise ist stets eine absolute Null-Lage gegeben (Spulenebene exakt senkrecht zu B₀). Das Großsignalverhalten ist völlig problemlos. Die Nullreferenz kann im Prinzip nicht verloren gehen. Es ergeben sich keine Störungen des B₀-Feldes, wenn Verstärker hochohmig ist (FET), da dann zwar eine Spannung induziert wird, aber kein Strom fließt. Außerdem ist keinerlei Temperaturabhängigkeit der Anordnung zu befürchten. Für diese Anwendung erscheint daher ein solcher Detektor ideal.

Diese Weiterbildung kann dadurch noch weiter verbessert werden, dass die Pick-Up Schlaufen im Mittel in der Arbeitsposition im Wesentlichen mit der Fläche senkrecht zum homogenen Magnetfeld B₀ ausgerichtet sind. Dann ist in der Arbeitsposition die Nutz-Ausgangsspannung genau Null. Dies hat den Vorteil, dass eventuelle Instabilitäten im Verstärkungsfaktor der Verstärkerelektronik sich nicht negativ auswirken, da stets auf Null geregelt wird. Allerdings sollte zur Erzielung des optimalen Effekts die Mechanik exakt justiert sein.

Bei einer weiteren Verbesserung weist die Detektionsvorrichtung eine Einrichtung zur phasensensitiven Detektion der induzierten Spannung in der (den) Pick-Up Schlaufe(n) auf. Dies ermöglicht eine bequeme Signalauswertung und hat den Vorteil, dass statische Nullpunktdriften in der Verstärkerelektronik keine Rolle spielen, da das Nutzsignal auf eine von Null verschiedene Frequenz moduliert wurde.

Um die gewünschte Information über die B_{T} Komponente bei der Grundfrequenz f zu erhalten und die von der unerwünschten 2f Komponente, die vom statischen Feld B₀ kommt, zu trennen, sollte die phasensensitive Auswertung der induzierten Spannung in der Pick-Up Schlaufe mit der Grundfrequenz der Kippbewegung erfolgen.

Eine Erhöhung des Nutzsignals bei f bei gleichzeitiger Verringerung des Störsignals bei 2f ergibt sich, wenn zwei oder mehrere entgegengesetzt periodisch verkippte Pick-Up Spulen so geschaltet sind, dass sich die B_{T} Signalkomponenten addieren.

Diese Weiterbildung kann noch dadurch weiter verbessert werden, dass die entgegengesetzt verkippten Spulen so dimensioniert sind, mit solchen Kippamplituden betrieben werden und so geschaltet sind, dass sich die sich durch das homogene Magnetfeld B₀ ergebenden Signalkomponenten möglichst exakt subtrahieren. Damit ergibt sich eine Erhöhung des Nutzsignals bei f bei gleichzeitiger Eliminierung des Störsignals bei 2f. Dies erlaubt eine höhere Kippamplitude und somit ein größeres Nutzsignal, was der Empfindlichkeit und Stabilität zugute kommt.

Bei einer grundlegenden Ausführung zur Erhaltung der zwei benötigten B_{T} Komponenten ist für jeden der mit den transversalen Magnetfeldkomponenten B_{T} verknüpften Freiheitsgrade je eine Pick-Up Spule oder ein Spulenpaar oder ein aus mehreren Pick-Up Spulen bestehendes Spulensystem vorgesehen.

Alternativ kann aber auch für beide mit den transversalen Magnetfeldkomponenten B_{T} verknüpften Freiheitsgrade nur eine einzige Pick-Up Spule, ein Spulenpaar oder ein Spulensystem vorgesehen sein, die bzw. das um zwei nicht parallele Achsen periodisch verkippt wird. Dadurch wird eine Spule eingespart.

Dies kann dadurch verbessert werden, dass die Verkippbewegungen zeitlich phasenverschoben, vorzugsweise um 90° phasenverschoben sind, und dass die Auswertung der induzierten Spannung durch zwei phasensynchrone Detektoren erfolgt, deren Referenz-Phasen gegeneinander ebenfalls phasenverschoben und mit den Verkippbewegungen synchronisiert sind. Dies dürfte die einfachste technische Ausführung sein, um die beiden Signale zu trennen, wenn für beide Kippachsen die gleiche Frequenz verwendet wird. Hierbei ist nur eine Frequenz nötig, dafür aber mit beiden Phasenlagen.

Hohe Genauigkeit und Langzeitstabilität lassen sich bei einer Weiterbildung erreichen bei der die Detektionsvorrichtung zur Messung der transversalen Magnetfeldkomponenten B_{T} ein NMR Sende/Empfangssystem umfasst, das mittels der Bestimmung einer Kernresonanzfrequenz den absoluten Betrag des Magnetfelds in der Messvolumens bestimmt, und bei dem mittels supraleitender, benachbarter Strukturen transversale Feldkomponentenänderungen dB_{T} in longitudinale Feldkomponentenänderungen dB₀ umgewandelt werden. Die SL-Struktur kann u.U. auf dem gleichem Substrat angeordnet sein wie die SL-Spule selbst. Damit wird eine sehr exakte Messung ermöglicht.

Eine andere vorteilhafte Weiterbildung zeichnet sich dadurch aus, dass die auf die Detektionsvorrichtung wirkenden transversalen Feldkomponentenänderungen dB_{T} weitgehend denen entsprechen, die auf die supraleitenden Komponenten des HF-Resonators wirken, und dass eine Regeleinrichtung, vorzugsweise ein Pl oder PID Regler vorgesehen ist, welche die mit der Detektionsvorrichtung gemessenen transversalen Magnetfeldkomponenten B_{T} konstant, insbesondere auf Null regelt.

Vorteilhaft ist auch eine Weiterbildung, bei der die Detektionsvorrichtung außerhalb des vollständigen Einflusses der Kompensationsvorrichtung angeordnet ist, und bei der die Wirkung der Kompensationsvorrichtung entsprechend der gemessenen Transversalfeldkomponenten so gesteuert wird, dass im Bereich der supraleitenden Komponenten des HF-Resonators die transversalen Magnetfeldkomponenten B_{T} konstant gehalten werden. Bei Platzproblemen kann dadurch der Detektor auch weiter weg von der SL Spule angebracht werden.

Wenn genügend Platz für den Detektor vorhanden ist, können die korrekten Transversalfeld-Komponenten B_{T} dadurch gemessen werden, dass die Detektionsvorrichtung in unmittelbarer Nähe der supraleitenden Komponenten des HF-Resonators angeordnet ist.

Vorteilhaft ist auch eine Ausführungsform des erfindungsgemäßen NMR-Spektrometers, bei der die Detektionsvorrichtung in unmittelbarer Nähe des magnetischen Zentrums der Magnetanordnung zur Erzeugung eines homogenen statischen Magnetfeldes B₀, insbesondere innerhalb eines Gebiets mit |dB₀/dz| < 10⁻²T/mm (100G/mm) angeordnet ist. Wenn das Feld inhomogen ist, ist nämlich die Messung von B_{T} abhängig vom genauen Ort des Detektors. Dies kann zu Messfehlern führen, die mit der obigen Ausführungsform vermieden werden. Es muss allerdings ausreichender Platz im besagten Bereich vorhanden sein.

Bei einer weiteren vorteilhaften Ausführungsform ist die Detektionsvorrichtung radial außerhalb eines Gradientensystems angeordnet. Dadurch ergibt sich ein geringerer Einfluss durch Gradientenfelder, obwohl die Detektionsvorrichtung trotzdem sehr nahe am Ort der SL Spulen angeordnet ist. Dafür muss allerdings radial Platz um die Gradientenspulen geschaffen werden.

Vorteilhaft wird ein abgeschirmtes Gradientensystem eingesetzt, so dass der Einfluss durch Gradientenfelder vernachlässigbar ist.

Bei einer weiteren bevorzugten Ausführungsform ist die Detektionsvorrichtung auf der Magnetachse angeordnet oder so aus mehreren Teildetektoren um die z-Achse herum zusammengesetzt, dass sie effektiv die auf der z-Achse auftretenden transversalen Magnetfeldkomponenten B_{T} misst. Da der Detektor nicht genau am Ort der SL Spule sein kann, wird durch Mittelung der Einzelmessungen die bestmögliche Abschätzung von B_{T} am Ort der SL Spule bestimmt.

Bei Verkippungen der SL Spule ergeben sich minimale seitliche Verschiebungen, die aber zu mechanischen Kollisionen sowie Beschränkungen der möglichen Verkippwinkel führen könnten. Bei einer vorteilhaften Ausführungsform verlaufen daher die Drehachsen der Kompensationsvorrichtung durch die supraleitenden Komponenten des HF-Resonators

Bei einer weiteren Ausführungsform können die Drehachsen der Kompensationsvorrichtung durch die Detektionsvorrichtung verlaufen. Dadurch verschiebt sich der Detektor während der Regelvorgänge nicht, und es werden keine zusätzlichen Messfehler eingeführt, die sonst die Qualität der Regelung beeinträchtigen könnten.

Besonders bevorzugt ist auch eine Ausführungsform des erfindungsgemäßen NMR-Spektrometers, bei der die Kompensationsvorrichtung über weitere Signaleingänge verfügt, mit denen zusätzliche Korrekturen der transversalen Felder durchgeführt werden können, die durch weitere Einflüsse, insbesondere durch mechanisches Kriechen oder thermisches Verformen von Komponenten, verursacht werden. Damit ergeben sich Eingriffmöglichkeiten zur Kompensationen von bekannten Artefakten oder Fehlfunktionen sowie zur Feinabstimmung.

Vorteilhaft kann die Kompensationsvorrichtung einen oder mehrere Piezo-Aktuatoren zur Verkippung der supraleitenden Komponenten des HF-Resonators aufweisen. Die Piezo-Aktuatoren funktionieren im Magnetfeld, erzeugen aber ihrerseits keine Magnetfeldstörungen. Für die kleinen Verkippwinkel sollte auch der Arbeithub ausreichend sein. Es erfolgt keine Leistungsaufnahme in der Ruheposition.

Bei einer weiteren bevorzugten Ausführungsform weist die Kompensationsvorrichtung zur Verkippung der supraleitenden Komponenten des HF-Resonators eine oder mehrere Leiterschlaufen auf, die mit von einer Steuerelektronik erzeugten Strömen versorgt und durch Lorentzkräfte im Magnetfeld bewegt werden. Der Hub kann nahezu beliebig groß sein, die Lösung ist preisgünstig und es sind keine hohen Spannungen, wie z.B. bei Piezo-Aktuatoren erforderlich.

In den Rahmen der vorliegenden Erfindung fällt auch ein Verfahren zum Betrieb eines erfindungsgemäßen NMR-Spektrometers, bei dem die Auswertung der Störungen unter Berücksichtigung von bekannten Einflüssen, die durch ein Shimsystem erzeugt werden, erfolgt. Damit lässt sich die Kontrolle der Transversalfeld-Komponenten perfektionieren.

Vorteilhaft ist auch ein Verfahren zum Betrieb eines erfindungsgemäßen NMR-Spektrometers, bei dem die Zusatzfelder, die durch Veränderungen der Einstellung des Shimsystems erzeugt werden, bei der Korrektur mit einberechnet werden.

Bei einer weiteren vorteilhaften Verfahrensvariante erfolgt die Auswertung der Störungen unter Berücksichtigung von bekannten Einflüssen, die durch ein Gradientensystem erzeugt werden. Damit lassen sich Regelstörungen durch das Gradientensystem verhindern, falls sie nicht durch konstruktive Maßnahmen genügend klein gehalten werden können.

Bei einer Verbesserung dieser Verfahrensvariante werden die Zusatzfelder, die durch das Schalten von Gradienten erzeugt werden, bei der Korrektur mit berücksichtigt und/oder dass während der Zeit, in der der Gradient geschaltet wird, keine Korrekturen vorgenommen. Das "Blanking" ist die einfachste Möglichkeit, die oben beschriebenen Störungen unwirksam zu machen. Es erfordert nur eine digitale Verbindung, aber keine Eichung.

Bei einer weiteren bevorzugten Verfahrensvariante wird die Kompensationsvorrichtung bereits vor oder während des Abkühlens der supraleitenden Komponenten des HF-Resonators aktiviert, und bleibt während der Kühlung unter die Sprungtemperatur T_{c} aktiviert. Damit wird nicht nur die nachträgliche Entstehung von Abschirmströmen im SL Resonator verhindert, sondern von vorneherein bereits deren Entstehung. Die Schwingspulenanordnung ist geradezu prädestiniert für diese Betriebsart, da sie vollkommen temperaturunabhängig funktioniert, denn sie erfordert Detektoren und Aktuatoren, die bereits über der Sprungtemperatur T_{c} der SL Spule aktiv sind und im gesamten Temperaturbereich die notwendige Genauigkeit aufweisen.

Bei einer alternativen Verfahrensvariante wird die Kompensationsvorrichtung zu einem beliebigen Zeitpunkt, insbesondere nach einer Entmagnetisierung der supraleitenden Komponenten des HF-Resonators, eingeschaltet, um die zu diesem Zeitpunkt anliegenden B_{T}-Felder konstant zu halten. Wird einmal ein störungsfreier Zustand (wie auch immer) erreicht, so kann dieser "eingefroren" werden.

Besonders bevorzugt schließlich ist auch ein Verfahren zum Betrieb eines erfindungsgemäßen NMR-Spektrometers, bei welchem zusätzlich zu einer aktiven Kontrolle gleichzeitig auch eine Dämpfung der hochfrequenten Transversalfeldkomponenten mit einem Transversalfeld-Schild erfolgt. Sehr vorteilhaft ist dabei die Kopplung der passiven und aktiven Methoden, um einerseits die Präzision zu erhöhen und/oder Störungen, die nicht geregelt werden können oder die Regelung beeinträchtigen, stark zu reduzieren.

Die Regelung darf allerdings nie Abweichungen von B_{T} über einem gewissen maximalen Wert zulassen, denn sonst wird der SL Resonator durch Überschreiten seines kritischen Stromes irreversibel magnetisiert, und muss dann entweder entmagnetisiert oder aufgewärmt werden. Dieses Überschreiten kann bereits durch beliebig kurze, ungeregelte Exkursionen geschehen, z.B. durch einen Stoß. Vermag die Regelung nicht im vollem Umfang und Geschwindigkeit in Echtzeit nachzuregeln, so passiert dies unweigerlich. Darum ist ein normalleitender Schild als Ergänzung sehr wertvoll, verhindert er doch unkontrolliert schnelle B_{T}-Feldänderungen. Auch große B_{T} Änderungen kommen somit zwar durch, aber mit einer beschränkten Änderungsrate, so dass die Regelung/Steuerung dieser zu folgen vermag.

Weitere Vorteile ergeben sich aus den Zeichnungen und der Beschreibung. Ebenso können die vorstehend genannten und die noch weiter aufgeführten Merkmale erfindungsgemäß einzeln für sich und zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in Zeichnungen dargestellt und wird anhand von Ausführungsbeispielen näher erläutert. Es zeigen:
- Fig. 1: eine Prinzipskizze der erfindungsgemäßen Vorrichtung im schematischen Vertikalschnitt;
- Fig. 2: einen schematischen Vertikalschnitt durch ein NMR-Spektrometer mit supraleitfähigen Magnetspulen und Kryostat nach dem Stand der Technik;
- Fig. 3: ein Beispiel für eine supraleitende HF-Empfangsspulenanordnung nach dem Stand der Technik , und zwar in Fig. 3a perspektivisch und in Fig. 3b als Schnitt in der xz-Ebene;
- Fig. 4: die Magnetfeldlinien der Grundfeldspule im ungestörten Fall;
- Fig. 5: die Magnetfeldlinien der Grundfeldspule im gestörten Fall und zwar in Fig. 5a durch Verkippung der HF-Empfangsspulenanordnung und in Fig. 5b durch Verkippung des Magnetspulensystems;
- Fig. 6: a) die transversale Magnetisierung M_{T}
b) die Auswirkungen einer Änderung der transversalen Magnetfeld komponenten dB_{T} auf die Homogenität der Magnetfeldkomponente B_{z} am Probenort;
- Fig. 7: eine schematische räumliche Ansicht einer erfindungsgemäßen Anordnung zur Kontrolle von Bₓ und B_{y} mit 2 Freiheitsgraden (Verkippung);
- Fig. 8: einen schematischen Vertikalschnitt durch eine Anordnung mit Verkippung der Spulen, aber mit fixem Detektor;
- Fig. 9: eine Anordnung mit Detektor außen an einem Gradientensystem;
- Fig.10: eine Anordnung mit Drehachse innerhalb des Bereichs der HF-Empfangsspulenanordnung;
- Fig.11: eine Anordnung mit Kompensation durch Einsatz von Feldspulen;
- Fig.12: eine räumliche Skizze einer Anordnung mit 2 Feldspulen zur Kontrolle der Magnetfeldkomponenten Bₓ und B_{y};
- Fig.13a-d: prinzipielle Anordnung einer erfindungsgemäßen Detektionsvorrichtung in mehreren Ausführungsformen;
- Fig.14a,b: die Verstärkung der Empfindlichkeit einer Hall-Sonde durch einen SL Transformator;
- Fig.15a: die grundsätzliche Anordnung eines Detektors mit Induktionsschleife;
- Fig.15b: die Detektoranordnung mit kompensiertem Einfluss des homogenen Magnetfelds B₀;
- Fig.16a-f: eine Analyse der Funktionsweise einer Detektoranordnung mit Induktionsschlaufe;
- Fig.17: Ausführungen einer Detektoranordnung mit Induktionsschlaufe und 2 Detektionsrichtungen, und zwar in a) asymmetrischer und b) symmetrischer Anordnung;
- Fig.18: einen Transversalfeld-Detektor mit SQUID;
- Fig.19: einen Transversalfeld-Detektor unter Ausnutzung von NMR-Signalen und mit SL Element;
- Fig.20: ein Transversalfeld-Schild in schematischem Vertikalschnitt; und
- Fig.21 a-f: Ausführungsformen des Transversalfeld-Schildes nach Fig. 20.

Die vorliegende Erfindung betrifft das Gebiet der Kernspinresonanz (NMR). Insbesondere geht es hier um die Magnetisierung und zur magnetischen Konditionierung von supraleitenden HF-Spulen zum Empfang von HF-Signalen aus einer Probe.

In Fig. 2 ist im schematischen Vertikalschnitt ein NMR-Spektrometer nach dem Stand der Technik dargestellt, das Grundfeldmagneten 1 zur Erzeugung eines homogenen statischen Magnetfeldes B₀ in Richtung einer z-Achse, sowie mit einem Hochfrequenz (=HF)-Resonator 2 zum Empfang von NMR-Signalen aus einem Messvolumen mit einem Probenröhrchen 3 mit, der eine oder mehrere supraleitende Komponenten enthält.

Die Magnetanordnung 1 kann eine oder mehrere supraleitfähige Spulen umfassen, welche in einem Gefäß 4 mit flüssigem Helium innerhalb eines Kryostaten 5 mit einer Raumtemperaturbohrung 6 untergebracht ist. Um die Wärmeleitung möglichst gering zu halten, ist das Gefäß 4 in einem lsoliervakuum 7 innerhalb des Kryostaten 5 mittels einer vertikalen Aufhängung 8 und einer seitlichen Aufhängung 9 angeordnet. Des weiteren umfasst die Anordnung ein Shimsystem 10 sowie einen Probenkopf 11, in welchem der HF-Resonator 2 untergebracht ist. Durch ein Isoliervakuum 12 sind Kühlleitungen 13 zur Kühlung der SL Elemente des HF-Resonators 2 über einen Wärmetauscher 15 geführt. Schließlich weist die Anordnung auch eine Zufuhrleitung 14 für Temperierluft zum Probenröhrchen 3 im Probenkopf 11 auf.

Das Ziel der vorliegenden Erfindung ist es, bei allen bekannten supraleitenden HF-Spulen, die durch die Spule hervorgerufenen Störungen des statischen Magnetfeldes und dadurch Artefakte in den Spektren praktisch zu eliminieren oder gegenüber dem Stand der Technik wesentlich zu reduzieren, sowie während der gesamten Benutzungsdauer tief zu halten.

Dies geschieht durch eine extrem präzise Kontrolle der auf die supraleitenden HF-Spulen 2 wirkenden transversalen Magnetfelder. Dadurch kann eine störende Magnetisierung von vorneherein verhindert werden. Zudem kann die erfindungsgemäße Vorrichtung einen störungsfreien Langzeitbetrieb gewährleisten. Erreicht wird dies durch eine aktive Kontrolle der transversalen Feldkomponenten und gegebenenfalls ergänzend durch passive Abschirmung mittels normal- oder supraleitender Schilde.

### A. Passive Abschirmung

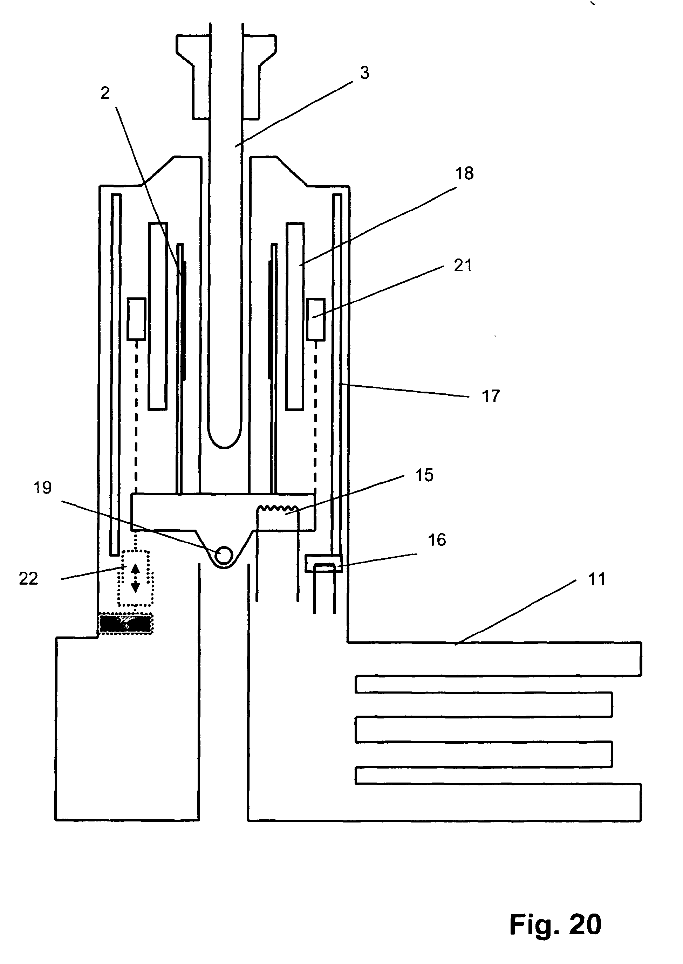

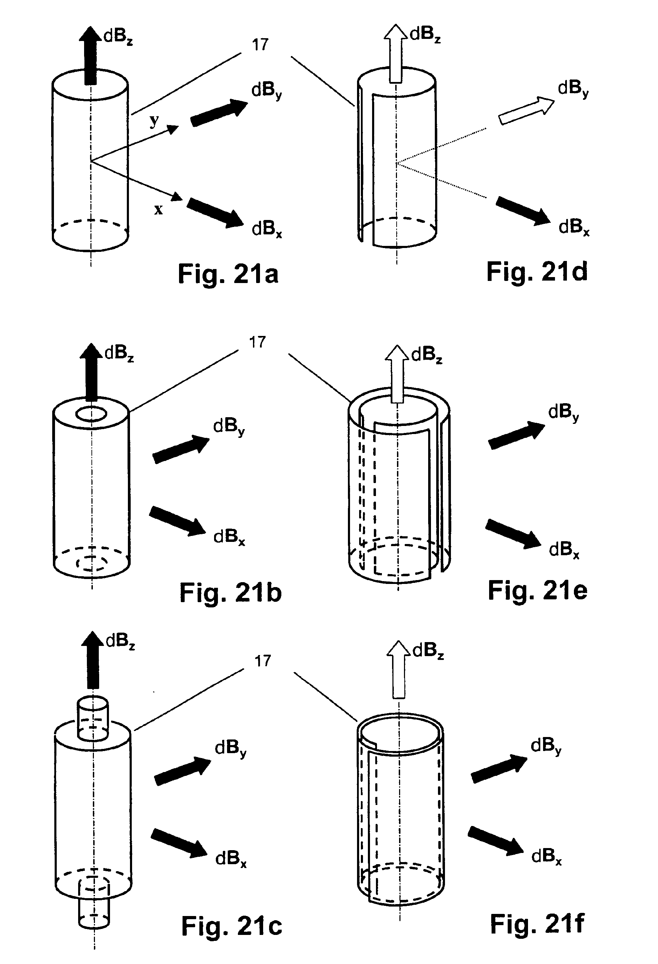

Dazu zählen Vorrichtungen wie
a) Abschirmung des Probenkopfes mit einem supraleitenden Schild, das in einer rein passiven Anordnung zunächst starr mit den HF-Spulen des HF-Resonators 2 gekoppelt ist. Die erste Möglichkeit ist, den Schild 17 direkt in den Probenkopf 11 einzubauen. Die mögliche Anordnung eines mittels einer Kühlvorrichtung 16 gekühlten Schildes 17 im Probenkopf 11 ist in Fig. 20 dargestellt. Radial innerhalb des Schildes 17 ist ein optionales Gradientensystem 18 sowie ein optionaler Magnetfeldsensor 21 sowie eine optionale Drehachse 19 vorgesehen.
   Dies hat jedoch u.a. den Nachteil, dass durch diesen Schild 17 hindurch nicht geshimmt werden kann. Um dieses Problem zu umgehen, muss der Schild 17 thermisch so ausgeführt werden, dass er nach Belieben unabhängig von den Spule unter T_{c} gekühlt werden kann, und somit das Innenfeld einfrieren oder aber durch Aufwärmen über T_{c} magnetisch durchlässig werden kann zum Shimmen.
   Die zweite Möglichkeit ist, dass sich der Schild 17 außerhalb des Shimsystems befindet und ebenfalls, falls größere Shimänderungen oder Nachladen des Magneten erforderlich werden, jederzeit über sein T_{c} heizbar sowie wieder durch T_{c} abkühlbar ausgeführt ist.
   Eine Positionierung des Schildes 17 außerhalb des Shimsystems führt aber wiederum, je nach der technisch erreichbaren mechanischen Starrheit der gesamten Anordnung, zu möglichen Verkippungen des Schildes 17 gegenüber den SL Spulen des HF-Resonators 2, denn der Schild 17 nimmt nun bezüglich des eingeschlossenen Feldes eigentlich die Funktion des Magneten ein. Ein solcher Schild kann aber dank seiner geringen Maße viel starrer aufgehängt sein als der Magnet selbst.
b) Eine weitere Ausführungsform ist ein Schild 17 aus einem normalleitenden Material, das um die SL-Spulen des HF-Resonators 2 herum angeordnet und in einer rein passiven Anordnung zunächst mechanisch starr mit ihnen verbunden ist. Obwohl ein normalleitender Schild nicht die DC-Komponenten einer transversalen Feldänderung aufhalten kann, vermag er doch hochfrequente Vibrationen und transiente Effekte zu dämpfen. Insbesondere wenn der Schild auf tiefe Temperaturen abgekühlt wird, kann er ein sehr effizientes Tiefpassfilter für die transversalen Felder bilden (da die elektrische Leitfähigkeit von z.B. Cu typischerweise um einen Faktor 100 gegenüber Zimmertemperatur zunimmt), so dass Effekte, die sich aus z.B. Schwingungen des Magneten ergeben, sehr effizient filtriert werden. Radial innerhalb des Schildes 17 ist ein optionales Gradientensystem 18 sowie ein optionaler Magnetfeldsensor 21 sowie eine optionale Drehachse 19 vorgesehen.
   Ausführungsbeispiele der Form solcher Schilde gemäß Punkt a) oder b) sind in den Figuren 21a bis f dargestellt. Die einfachen Varianten mit zunehmendem Abschirmungsgrad sind in den Figuren 21 a bis c dargestellt. Es ist zu beachten, dass je enger die Enden geschlossen sind, umso weniger können Feldänderungen von den Enden her eindringen.
   Auf jeden Fall ist aber zu beachten, dass sie Öffnungen für die Probe selbst sowie für die Temperierluft aufweisen müssen.
   In den Figuren 21 d bis f sind schließlich diverse geschlitzte Varianten aufgeführt, die einerseits das Eindringen transversaler Felder B_{T} verhindern bzw. filtrieren, andererseits aber die Änderung des statischen Felder B₀ erlauben. Dies kann nötig sein beim Wechsel von Proben zur Regelung der genauen Resonanzfrequenz bei Proben verschiedener magn. Suszeptibilität und erlaubt den normalen Betrieb des Lock-Systems. In den Figuren 21 sind der Klarheit halber diejenigen Komponenten der Feldänderungen, die gedämpft werden, mit einem schwarzen Pfeil gekennzeichnet.
c) Mechanische Ausrichtung der NMR Spulen z.B. an einer Magnetnadel, die sich parallel zum Magnetfeld ausrichtet. Dies scheitert jedoch am Problem, dass das Feld der Magnetnadel die Homogenität des NMR B₀ Feldes zerstört wie auch an der sehr geringen wirkenden Kraft, so dass die Genauigkeit eines solchen Systems mehr als fraglich ist. Es soll hier nicht weiter auf diese Lösungen eingegangen werden.

### B. Aktive Abschirmung

Solche Systeme messen die tatsächlichen transversalen Komponenten und korrigieren sie mit einer aktiven Regelvorrichtung. Diese Systeme werden bevorzugt, denn sie sind, wie weiter unten gezeigt wird, tatsächlich ohne größere Schwierigkeiten technisch realisierbar. Ein solches System ist auch sehr flexibel in der Implementation wie auch im Betrieb. Aus diesem Grunde befasst sich der vorwiegende Teil der Beschreibung der vorliegenden Erfindung mit der aktiven Variante, bei der eine aufkommende Störung gemessen und durch eine Kompensationsvorrichtung wieder kompensiert wird, bevor signifikante Störungen im NMR Spektrum auftreten.

Die Kompensationsvorrichtung ist technisch recht gut realisierbar, sei es durch aktives mechanisches Verkippen der supraleitenden HF-Spulen oder durch zusätzliche transversale Feldspulen. Es sind aber ebenfalls Realisationsvarianten möglich, bei denen die gesamte Magnetspule des NMR Magneten in ihrer Ausrichtung kontrolliert wird.

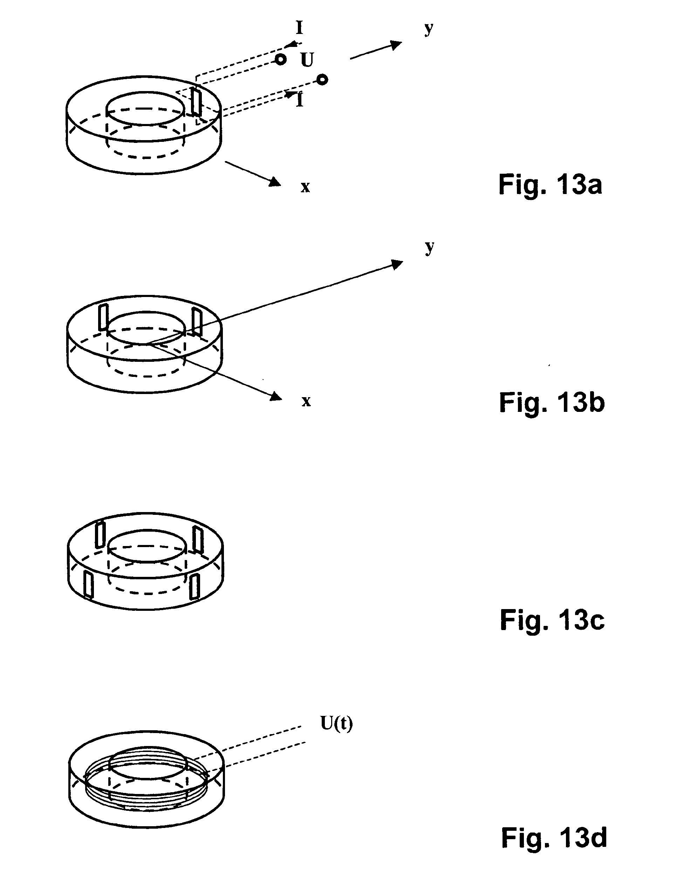

Die Schwierigkeit einer aktiven Anordnung liegt aber sicherlich bei einem geeigneten Detektor, der die extrem kleinen transversalen Felder empfindlich und stabil messen muss. Die praktische Durchführbarkeit der aktiven Realisation der vorliegenden Erfindung ist eng mit der Machbarkeit eines genügend guten Detektors verknüpft. Ein solcher Transversalfeld-Detektor ist in diversen Ausführungsformen in den Figuren 13 a bis d prinzipiell dargestellt.

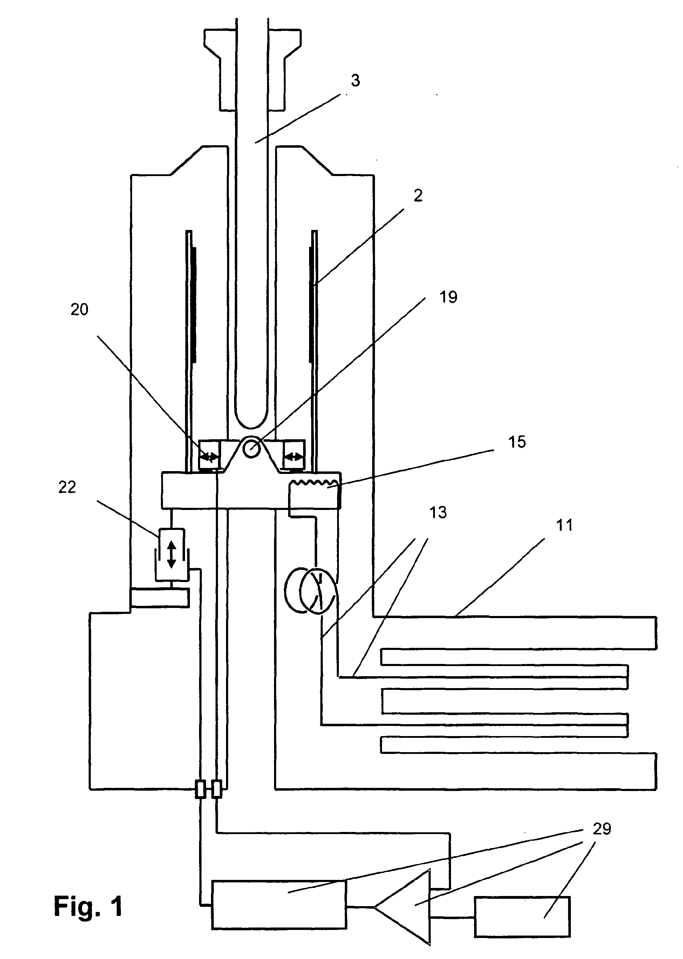

Wir stellen ihn der Konsistenz halber in allen Darstellungen als ein Toroid dar, der im einfachsten Falle lediglich z.B. eine Hallsonde enthält, die eine Komponente (z.B. By) des transversalen Magnetfeldes misst (Fig. 13a), wobei der Toroid um die Symmetrieachse des Probenkopfes 11 angeordnet ist (siehe z.B. Transversalfeld-Detektor 20 in Fig. 1). Die innere Implementation kann aber ganz verschieden ausfallen, wie z.B. mit zwei oder vier Hallsonden (Fig. 13b, 13c), oder aber eine schwingende Pick-up Spule (Fig. 13d, Erläuterungen siehe weiter unten).

Der Detektor muss aber nicht zwangsläufig im Probenkopf selbst eingebaut sein, sondern kann prinzipiell an irgendeiner Position des NMR Systems platziert werden, bei dem die Beziehung zwischen der Ausrichtung der NMR Spulen und dem Detektor definiert ist. Insbesondere kann der Detektor auch als Teil des Shim- oder sogar des Magnetsystems selbst implementiert werden.

Die Realisierung eines so extrem genauen Detektors, der alle Anforderungen erfüllt, ist jedoch überraschenderweise möglich, wie im Folgenden an einem Beispiel gezeigt wird: Ein Ausführungsbeispiel eines solchen Detektors für transversale Feldkomponenten (schwingende Spule) kann genau analysiert werden. An diesem Ausführungsbeispiel kann gezeigt werden, dass es technisch möglich ist, eine Vorrichtung ("Detektor" genannt) zu bauen, der auch in der Anwesenheit eines sehr starken longitudinalen statischen Magnetfeldes (> 10 T (100'000 G)) transversale Feldkomponenten mit einer Genauigkeit < 10⁻⁴T(1G) langzeitstabil messen kann!

Kurze Bemerkungen zur technischen Realisation eine solchen Detektors:

### 1. Einfachste Ausführung:

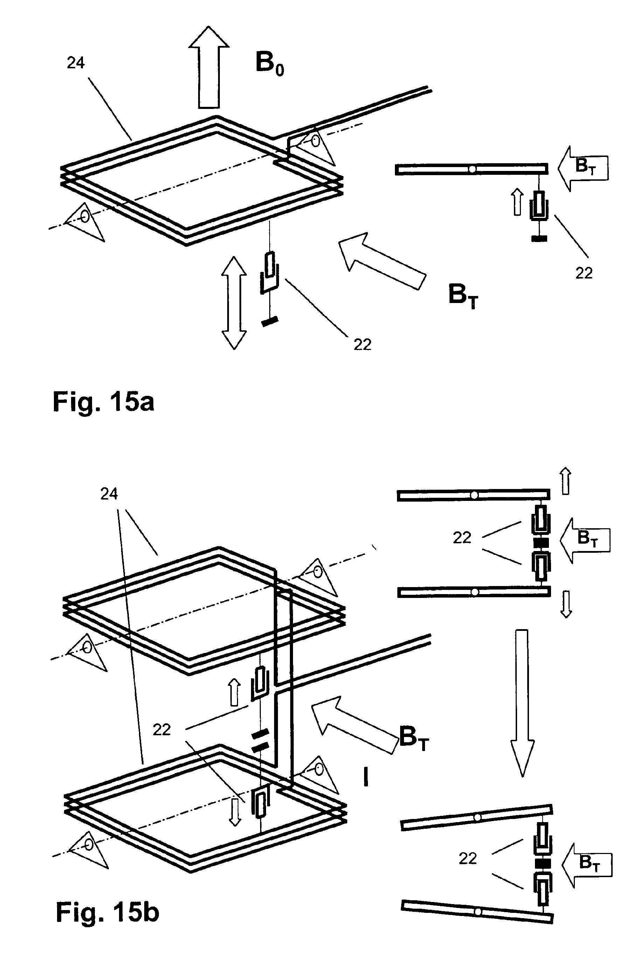

Diese ist in Fig. 15a prinzipiell dargestellt. Eine Spule mit einer Fläche von ca. 1cm², die mit 100 - 1000 Windungen eines dünnen Drahtes gewickelt ist, ist mit der Fläche zunächst genau senkrecht zum B₀ Feld ausgerichtet. Diese Spule besitzt einen oder mehrere mechanische Aktuatoren 22, die sie um eine (oder zwei) Achsen, die in der Spulenebene liegen und senkrecht zu B₀ sind, periodisch um die Ausgangslage oszillieren lassen. Die Frequenz der Oszillation kann typischerweise im Bereich 1 kHz - 10 kHz liegen. Die Amplitude kann sehr gering sein, typischerweise ca. 100 - 1000 nm betragen. Die Spule wird an einen empfindlichen Spannungsverstärker angeschlossen, mit einer spektralen Rauschdichte von typischerweise 1nV/Hz^{0.5}.

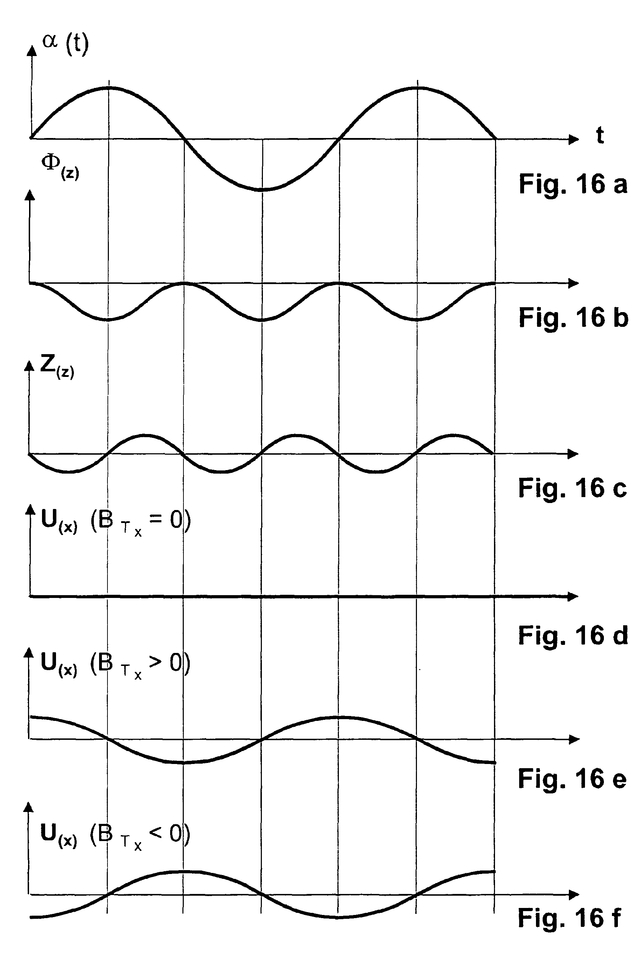

Eine prinzipielle Analyse ist in den Figuren 16 a bis f dargestellt: Fig. 16a zeigt die periodische Verkippung alpha (t) der Spule um die y-Achse gegenüber ihrer Ruheposition in einer Ebene xy senkrecht zu B₀.:

Am Ausgang des Verstärkers ergeben sich zwei charakteristische Signale, mit unterschiedlichen Frequenzen:
a) Longitudinales Signal U_{(z)}: Ein extrem kleines Signal mit der doppelten Frequenz der Schwingung, das daher kommt, dass die effektive Fläche in B₀ Richtung mit dem cosinus des Neigungswinkels abnimmt. Dies führt zu einem zeitabhängigen, auf beide Kippseiten hin abnehmenden Fluss Phi_{z}(alpha) (Fig. 16b). Dies führt zu einer induzierten Spannung gemäß U=dPhi/dt, die in Fig. 16c) dargestellt ist. Die Amplitude dieses Signals ist extrem klein, da sie quadratisch von der Amplitude der Schwingung abhängt.
b) Transversales Signal U₍ₓ₎: Beim Vorliegen von keinerlei transversalen Feldern haben wir (aus Symmetriegründen schon) kein Signal mit der einfachen Anregungsfrequenz (Fig. 16d). Wird jedoch ein (bereits sehr kleines) transversales Feld B_{Tx} angelegt (in Richtung senkrecht zur Schwingungsachse und B₀), so wird in der Spule ein Signal induziert, das linear mit der Amplitude von B_{Tx} zusammenhängt. Bei einer phasensynchronen Detektion (mit der mech. Schwingung als Referenz) ist die Phase vom Vorzeichen von B_{T} abhängig (Fig. 16e, bzw. 16f beim B_{T} mit negativem Vorzeichen).

Zusammengefasst kann gesagt werden, dass mit der obigen Anordnung und einer phasensynchronen Detektion synchron mit der mechanischen Anregungsfrequenz ein Signal gewonnen werden kann, das proportional zur transversalen Feldkomponente senkrecht zur Kippachse ist. Eine einfache Berechnung zeigt, dass ein hinreichend großes Signal (in der Größenordnung 100nV - 10µV) erhalten werden kann, um Feldabweichungen von 10⁻⁴T(1G) zu detektieren.

Dieses Nutzsignal ist überlagert vom Hintergrundsignal, stammend von B₀. Dieses kann aber unter Verwendung von einem Lock-In Verstärker einfach getrennt werden, da das Hintergrundsignal mit der doppelten Frequenz als das Nutzsignal auftritt. Da das Hintergrundsignal quadratisch und das Nutzsignal linear von der Schwingungsamplitude abhängt, kann durch die geeignete Wahl einer hinreichend kleinen Schwingungsamplitude die Störung durch das Hintergrundsignal im Verhältnis zum Nutzsignal beliebig klein gemacht werden.

### 2. Verbesserte Ausführung:

Da bei einer Reduktion der Schwingungsamplitude auch das Nutzsignal kleiner wird, ist es aus technischen Gründen nicht sinnvoll, die Amplitude unter ein bestimmtes Maß zu verringern. Im Gegenteil, man möchte die Schwingungsamplitude und somit das Nutzsignal möglichst groß haben. Mit einem einfachen Trick kann jedoch die Störung durch das Hintergrundsignal wesentlich reduziert werden:

Es wird eine Anordnung von zwei Spulen verwendet, die parallel zueinender angeordnet sind, parallele Achsen haben, um diese synchron schwingen, aber mit entgegengesetzter Phase (Fig. 15b). Die Ausgänge der beiden Spulen werden in Serie geschaltet und dem Verstärker zugeführt. Die Polarität der Serienschaltung ist so gewählt, dass sich die transversalen Signale addieren.

Eine einfache Analyse zeigt dann, dass bei einer Ausführung, bei der die Flächen und Amplituden (d.h. genauer gesagt, ihr Produkt) gleich sind, sich gleichzeitig eine exakte Subtraktion des B₀ Hintergrundbeitrags ergibt. Dies kann nun dazu benutzt werden, die Schwingungsamplitude beträchtlich zu vergrößern. Dadurch werden die Nutzsignale (die vom transversalen Feld B_{T}) stammen, sehr viel größer, ohne dass Störungen vom B₀ Feld auf der doppelten Frequenz die Auswertung stören.

### 3. Messungen der beiden transversalen Komponenten:

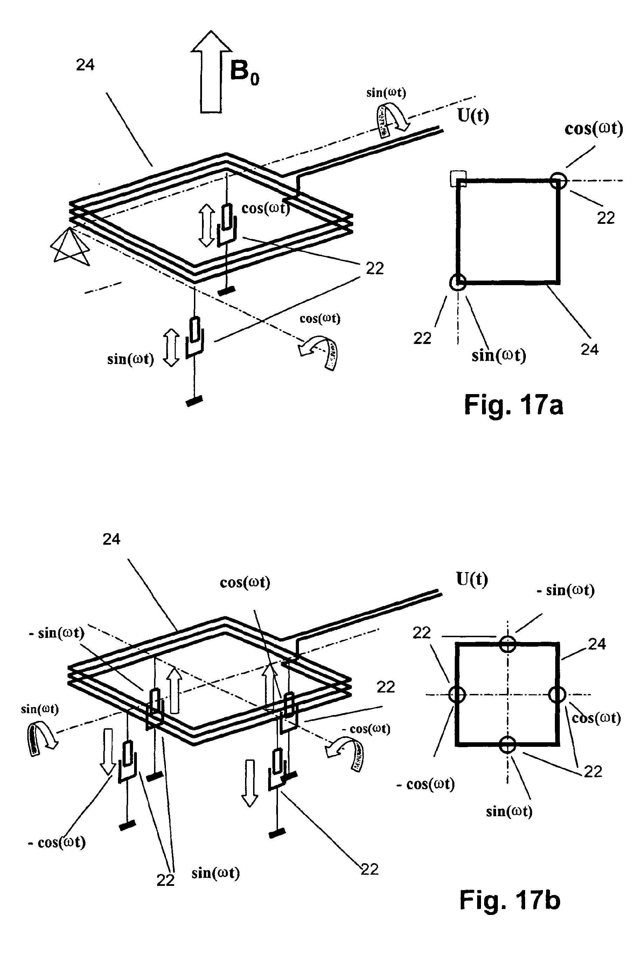

Die obigen Anordnungen können verwendet werden, um eine transversale Komponente B_{T} zu messen, z.B. Bₓ. Es ist aber im allgemeinen erwünscht, dass auch die andere Komponente, hier also B_{y}, gemessen wird. Dies kann auf verschiedene Arten geschehen:
a) Es wird einfach ein doppelter Satz der Spulen gemäß obigem Abschnitt 1 oder 2 verwendet, der eine Spulensatz mit der Kippachse(n) parallel zur y-Achse (zur Messung der Bₓ Komponente), und der andere entsprechend mit der Kippachse(n) parallel zur x-Achse (zur Messung der B_{y} Komponente).
b) Es kann nun einiges an Hardware gespart werden, wenn die Spulen gemäß 1 oder 2 mit zwei zueinander senkrechten Drehachsen versehen werden (z.B. eine Art Kardangelenk). Einfachere Ausführungen ohne Kardangelenk sind in den Figuren 17a und b dargestellt. Die Spulen werden um beide Achsen gleichzeitig verkippt, aber mit einer um 90 Grad verschobenen Phase (eine Art Taumelbewegung). Die Spannungen werden nun von einem Doppel-Lock-In Verstärker gemessen, der die beiden Phasenkomponenten in 0 und 90 Grad separat auswertet. Aus diesen werden dann die beiden Bₓ und B_{y} Signale gewonnen. Diese Anordnung hat den Vorteil, dass nur ein Satz Spulen und ein Verstärker sowie nur ein Signalpfad gebraucht werden und ist sowohl platz- wie auch kostensparend.

### 4. Bemerkungen zur Stabilität:

Da alle obigen Signale auf einer Trägerfrequenz aufmoduliert sind, führen Driften in der Elektronik zu keinen Nullpunktdriften. Auch die Verkippvorrichtung muss in vielen Fällen keine stabile Amplitude aufweisen sowie die Stabilität der Verstärkungsfaktoren muss nicht langzeitstabil sein, denn wenn es in Anordnungen verwendet wird, bei denen das Signal auf Null geregelt wird, spielt dies keine Rolle. Dies zusammen ermöglicht eine extrem gute Kurz- wie auch Langzeitstabilität des Systems, um die geforderte absolute Genauigkeit von 1G zu erzielen und langfristig zu halten.

### 5. Weitere Bemerkung zur Ausführung:

In der obigen Beschreibung werden die Verkippungen mit einem zu diesem Zweck dedizierten speziellen Aktuator 22 erzeugt. Dies muss nicht zwingend so sein, es sind Anordnungen möglich, bei denen die Kompensationsvorrichtung (s.u.) durch ein periodischen Zusatzsignal gleichzeitig auch zur Signalerzeugung verwendet werden kann.

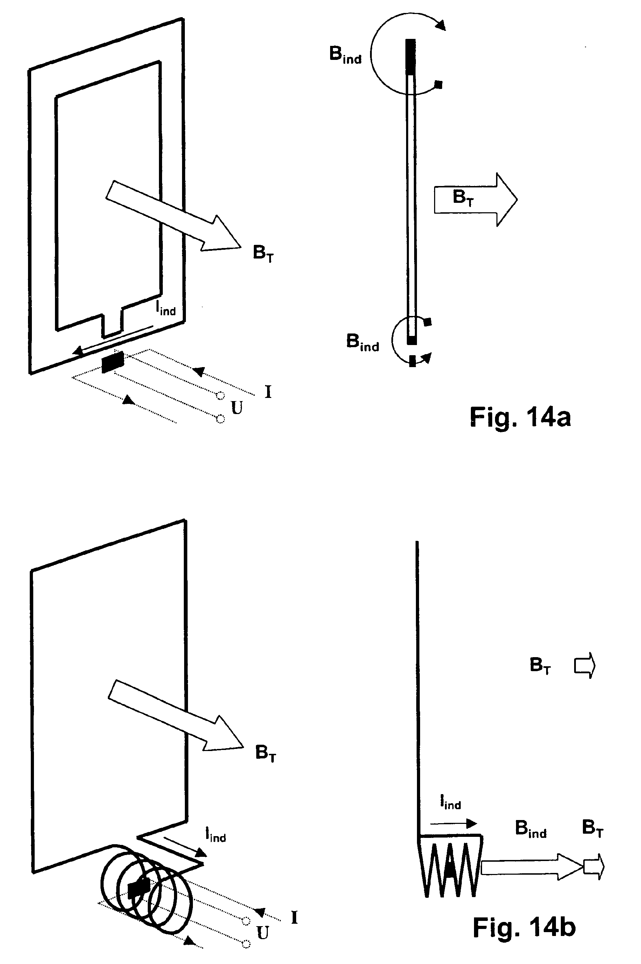

Es sind aber auch andere technische Realisationsformen eines Detektors für transversale Felder möglich, wie z.B. eine stabile Hall-Sonde, die mit ihrer empfindlichen Richtung senkrecht zum B₀ Feld positioniert wird (Fig. 13b). Sie misst dann die transversale Feldkomponente des Magnetfeldes. Diese kann in ihrer Empfindlichkeit mit einem kleinen supraleitenden Transformator bei Bedarf weiter erhöht werden (Figuren 14a und 14b).

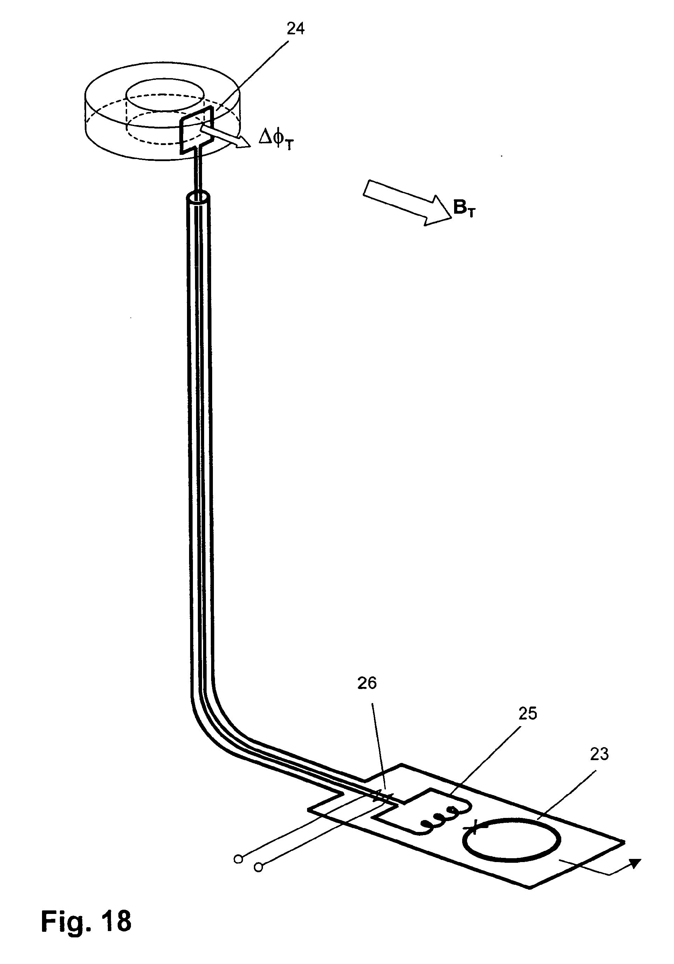

Es sind auch weitere, aufwendigere Verfahren denkbar, wie z.B. der in Fig. 18 dargestellte SQUID-Detektor mit einem SQUID 23 und einer Pick-Up Schlaufe 24. Da der SQUID ("Superconducting Quantum Interference Device") nicht selbst im Magnetfeld funktioniert, muss hier eine supraleitende Schlaufe 25 als Flusstransformator verwendet werden, wie dies bei der Anwendung von SQUID's für Magnetfeld- sowie Magnetisierungsmessungen üblich ist. Die abgeschirmte Signalleitung am Abgriff der supraleitenden Schlaufe 25 ist mit einer Heizvorrichtung 26 beheizbar.

Zu beachten ist hier, dass die Pick-up Schlaufe 25 senkrecht zum B₀ Feld, in der Richtung der zu messenden transversalen Magnetfeldkomponenten B_{T} orientiert sein muss.

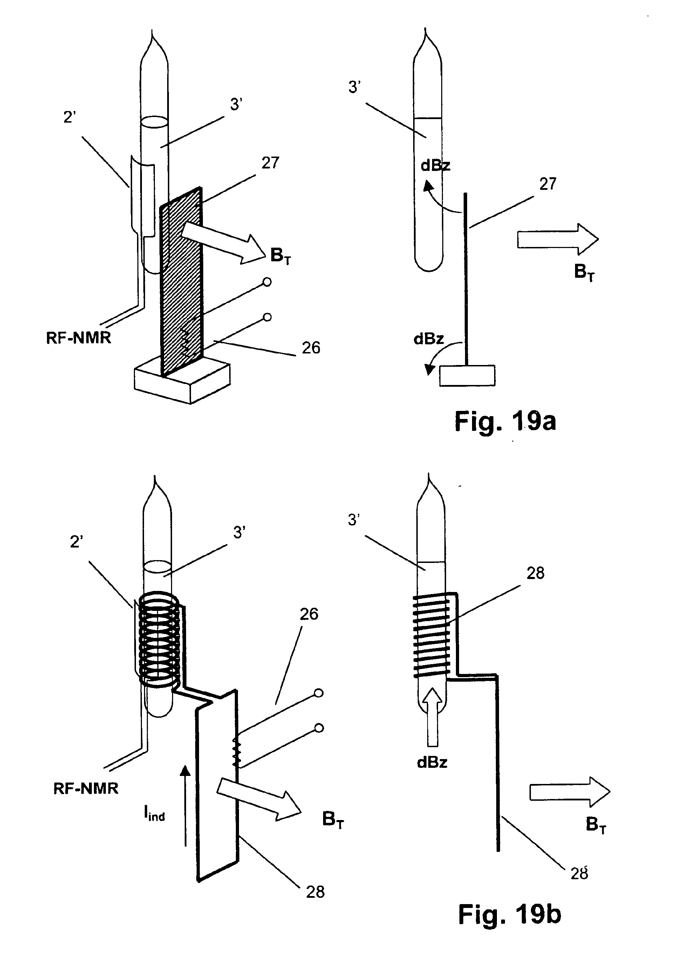

Es sind aber auch noch weitere Ausführungsformen realisierbar, wie eine indirekte Messung des transversalen Feldes durch eine kleine separate NMR Probe 3', die sich neben einem supraleitenden Element (in Fig. 19a supraleitfähige Fläche 27 mit neben der Probe 3' mit geeignet positionierter Diskontinuität, oder aber auch eine vorzugsweise supraleitfähige Transformations-Schlaufe 28 wie in Fig. 19b gezeigt) befindet, mit einer solchen Geometrie, dass dieses supraleitende Element die transversalen Feldänderungen dB_{T} in longitudinale Feldänderungen dB_{z} am Probenort transformiert (nach dem gleichen Prinzip wie eigentlich der Störungsmechanismus selbst, der eliminiert werden soll!). Diese Probe 3' wird nun in einer kontinuierlichen oder periodischen Messung (analog dem NMR Feldlock) mit Hilfe einer HF-Spule 2' , die zu einer NMR Hilfs-Spekrometervorrichtung führt, auf ihre NMR-Resonanzfrequenz hin gemessen. Die Abweichung von der Soll-Frequenz gibt dann direkt ein Maß für die transversale Feldkomponente B_{T}, die in der Richtung senkrecht zur supraleitenden Fläche 27 oder Schlaufe 28 wirkt.

Die Empfindlichkeit eines solchen Systems ist sicherlich genügend, denn es wird zur Messung der gleiche Mechanismus verwendet, der die unerwünschten Störungen verursacht. Dazu kommt, dass sich die Empfindlichkeit eines solchen Systems durch geeignete (möglichst "ungünstige") Geometrien des supraleitenden Elements 27, 28 noch beträchtlich steigern lässt.

Es ist zu bemerken, dass in allen Ausführungsvarianten mit einem supraleitenden Transformationselement (Figuren 18, 19a, 19b, und ggf. 14a und b) ausgerüstet sind, vorteilhafterweise mit einem kleinen Heizer 26 ausgerüstet werden, um die Ströme im Transformator und somit die Ausgangssignale bei Nominallage des Systems auf Null zu bringen.

Ein Transversalfelddetektor, in einer der obigen oder auch anderen denkbaren Ausführungsvarianten, kann nun verwendet werden, um eine (z.B. Bₓ) oder beide (z.B. B_{y}) Komponenten des transversalen Magnetfeldes zu messen. Bei supraleitenden Spulen z.B. gemäß [1], die nur in parallelen Ebenen in einer Orientierung angeordnet sind (Figuren 3 a und b), genügt i.A. die Kontrolle von B_{T} (d.h. hier Bₓ) senkrecht zur Supraleiterebene (yz) der HF-Spule(n).

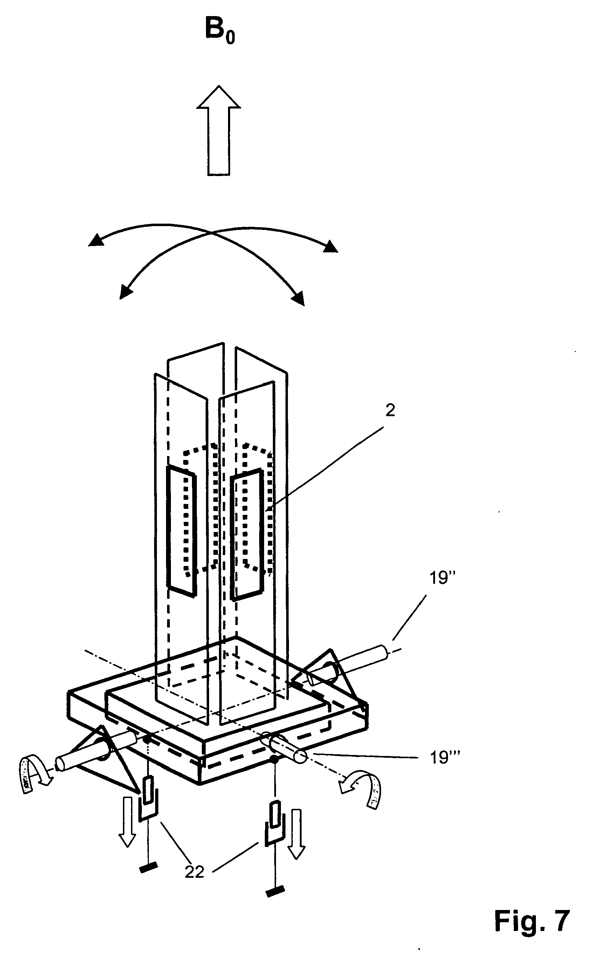

Bei komplizierteren Anordnungen oder Kombination von orthogonalen Spulenpaaren gemäß [1] müssen dann beide transversalen Magnetfeldrichtungen kontrolliert (durch 2-dimensionales Verkippen in Fig. 7 dargestellt) und somit auch gemessen werden.

Eine Prinzipdarstellung einer bevorzugten Implementation der erfindungsgemäßen Vorrichtung ist in Fig. 1 dargestellt. Der Transversalfeld-Detektor 20 misst also die auftretenden transversale Magnetfeldkomponenten B_{T}. Der Ausgang des Detektors 20 wird dann mittels einer Steuer/Regelvorrichtung mit einem Aktuator 22 einer Kompensations-Vorrichtung (Kippen der Spulen um einen Drehpunkt 19) verknüpft. Diese Kompensationsvorrichtung sorgt nun mittels eines Steuer/Regelkreises 29 dafür, dass die transversalen Feldkomponenten B_{T} am Ort der supraleitenden HF-Spulen 2 bei einer auftretenden Abweichung stets auf den Ursprungszustand zurückgeführt werden.

Als Kompensationsvorrichtung werden insbesondere mechanische Vorrichtungen zum Verkippen der SL Spulen verwendet. Diese erzeugen eine transversale Feldkomponente, die der Störung entgegenwirkt. Oder anders ausgedrückt, die SL Spulen werden z.B. bei einer Kippung des Magneten in gleicher Richtung und im exakt gleichen Winkel parallel zum Magneten mit verkippt. Somit folgen die Spulen stets der Richtung des Magneten, so dass keine transversalen Feldänderungen entstehen.

Der Antrieb des Verkippmechanismus kann vorzugsweise durch piezo-elektrische Aktuatoren oder aber auch durch elektromagnetische Kräfte bewerkstelligt werden, die auf Feldspulen wirken, die sich vorzugsweise im Magnetfeld B₀ des NMR Magneten befinden. Aber auch andere Antriebe, wie z.B. durch piezoelektrische Motoren, Elektromotoren, Schrittmotoren oder dgl. sind realisierbar.

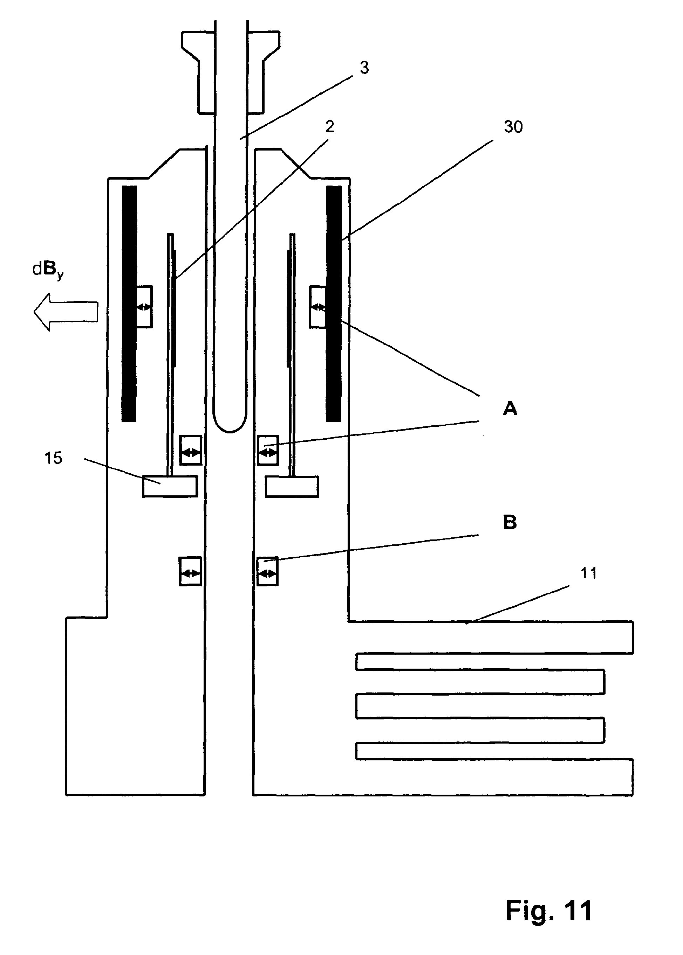

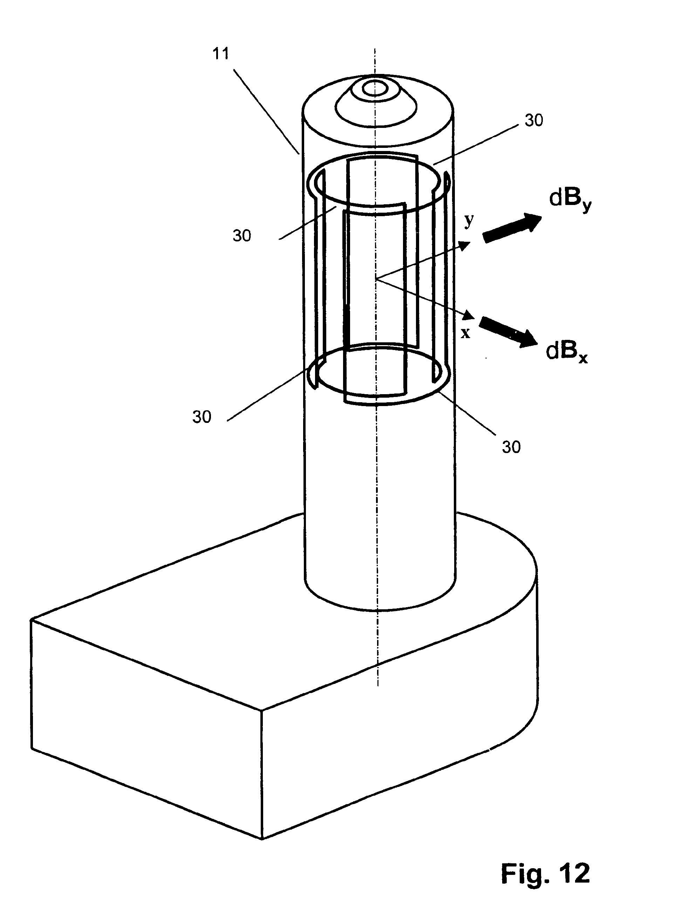

Die Kompensationsvorrichtung kann aber auch aus Feldspulen 30 bestehen, die ein zusätzliches transversales Feld in einer gewünschten Stärke und Richtung erzeugen. Dieses wird dann so gesteuert, das auch hier die transversalen Magnetfeldkomponenten B_{T} am Spulenort unverändert bleiben (Fig. 11, sowie Fig. 12 für beide Komponenten Bₓ und B_{y}). Diese Feldspulen 30 können im Probenkopf 11, im Shimsystem oder auch am oder im Kryo-Magnet angebracht werden.

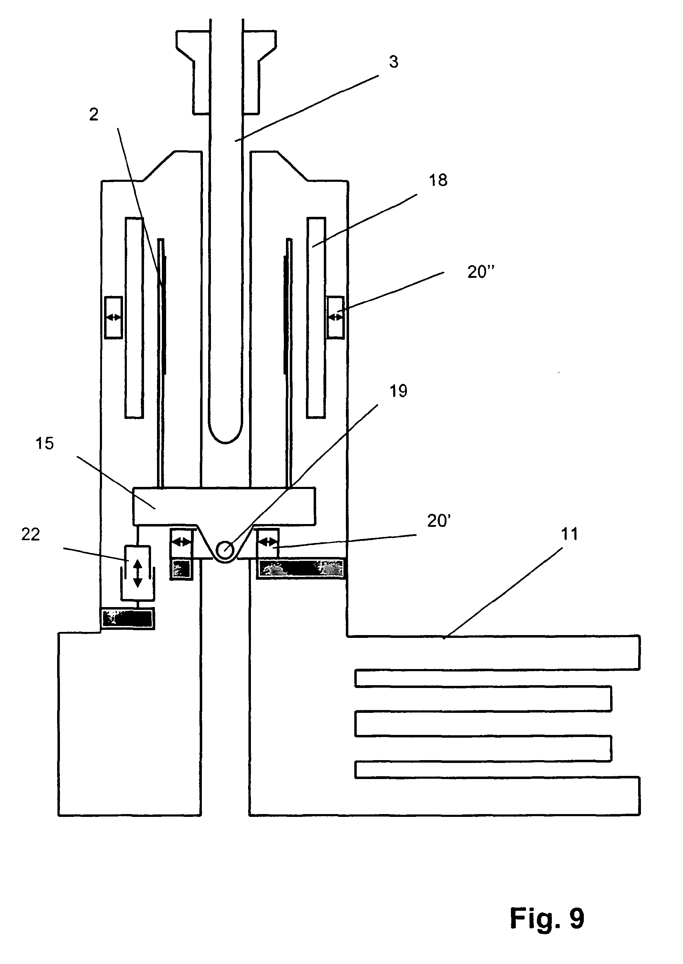

Bei einer bevorzugten Ausführungsform wird der in Fig.1 gezeigte Transversalfeld-Detektor 20 möglichst in der Nähe der supraleitenden Spulen angeordnet, und zwar unbeweglich, d.h. starr mit dem Probenkopf 11 verbunden (siehe Detektor 20" in Fig. 9), damit er möglichst genau auch die tatsächlich auf die Spulen wirkenden transversalen Feldkomponenten misst. Dann kann die Steuer/Regelvorrichtung die Kompensationsvorrichtung, bestehend aus einer Vorrichtung zum Verkippen der HF-Spulen, so steuern, dass die supraleitenden HF-Spulen stets im konstanten transversalen Feld verbleiben.

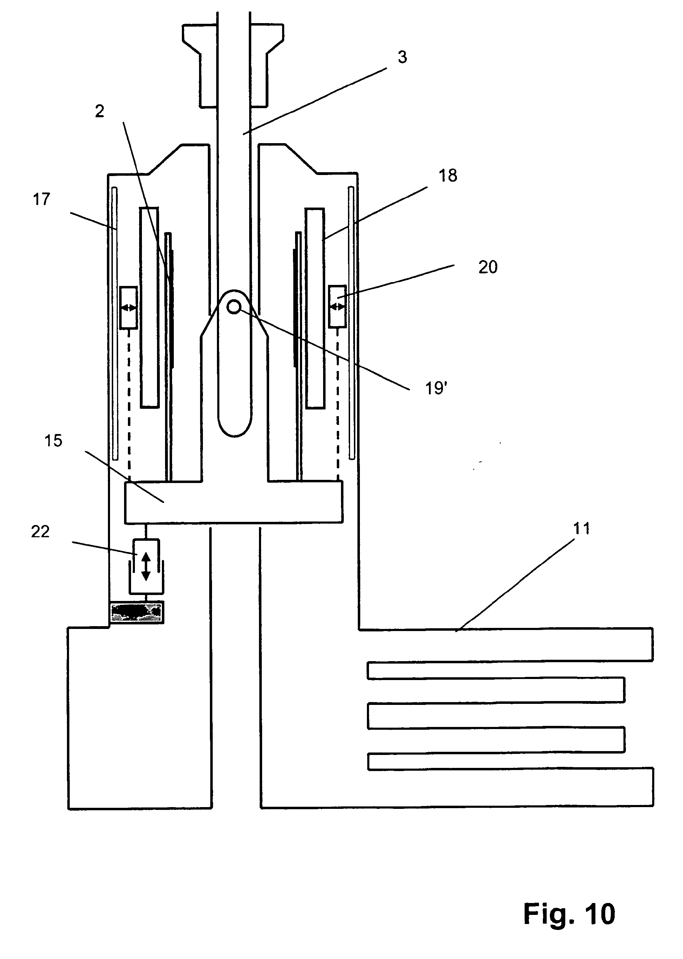

Bei einer weiter bevorzugten Ausführungsform wird der Transversalfeld-Detektor 20 möglichst in der Nähe der supraleitenden HF-Spulen 2 platziert, und mit ihnen starr winkelmäßig verbunden (siehe Fig. 10). Die Kompensationsvorrichtung verkippt nun die HF-Spulen 2 zusammen mit dem Detektor 20 um die Drehachse 19'. Dann kann die Regelvorrichtung einfach die Kompensationsvorrichtung stets so steuern, dass der Detektor 20 stets im konstanten transversalen Feld verbleibt, und somit auch die HF-Spulen 2.

Die gleiche Regelung auf Null Abweichung im Detektor kann auch angewendet werden, wenn Kompensationsspulen verwendet werden. Diese wirken dann auf die Spulen und den Detektor im gleichen Maße (Fig. 11, Position A).

Es ist auf jeden Fall günstig, den Detektor im homogenen Feldbereich zu platzieren, denn dann ist sichergestellt, dass der Detektor die gleichen Felder misst wie die HF-Spulen 2 erfahren. Ein gutes Maß ist es, den Detektor im Bereich zu platzieren, wo die Feldgradienten kleiner als 10T/m (100G/mm) sind.

Bei einer anderen Ausführungsform kann der Detektor auch in einer gewissen Entfernung von den HF-Spulen 2 platziert werden (Fig. 11, Position B), wenn dies durch technische oder konstruktive Erfordernisse nötig ist. In solchen Fällen ist sind die Störungen, die der Detektor misst, nicht mehr zwangsläufig identisch mit denen, die auf den supraleitfähigen HF-Spulen wirken. Insbesondere muss auch die Kompensationsvorrichtung nicht mehr gleich auf die HF-Spulen und den Detektor wirken. In einem solchen Falle sind kompliziertere Algorithmen nötig, um die Konstanz der B_{T} Felder zu gewährleisten (über eine einfache Steuerung des Kompensationswinkels, oder über eine Null-Regelung auf den Detektor hinausgehend). Dabei sind auch Anordnungen von mehreren Sensoren an verschiedenen Orten möglich, aus denen dann das effektive B_{T} Feld am Ort der Spulen ermittelt und daraus die nötige Kompensation bestimmt wird.

Was die Regelalgorithmen im Allgemeinen betrifft, so können diese im weiten Bereich dem Problem angepasst sein, die Regelung kann analog oder digital erfolgen, und die Regelbandbreite kann so gewählt werden, dass z.B. nur langsame Störungen kompensiert werden, oder aber auch Vibrationen und Schwingungen mit einer schnellen Regelschlaufe mit kompensiert werden.

Eine sehr günstige Konfiguration ist die Verbindung der Kompensationsvorrichtung mit einem normalleitenden Magnetfeldschild 17 (siehe Fig. 20). Dadurch werden die hochfrequenten Störungen (Vibrationen, etc.) ausgefiltert, und die niederfrequenten und quasi-statischen können nun gut mit der Kompensationsvorrichtung ausgeregelt werden.

Bei einer bevorzugten Anordnung wird der Schild 17 starr mit dem Probenkopf 11 verbunden, und die Anordnung, bestehend aus dem supraleitenden Resonator 2 und dem Detektor 21, ist um die Achse 19 gegenüber dem Probenkopf 11 kontrolliert kippbar, so dass die verbleibenden, durch den Schild 17 gedämpften und somit langsamen B_{T} Änderungen mit einer im Verhältnis dazu raschen Regelschlaufe auf einfache Weise präzise ausgeregelt werden können.

Dieses Prinzip der Kopplung der passiven und aktiven Stabilisierung kann auch bei einem supraleitenden Schild angewandt werden.

Bei den Vorrichtungen, die mit Verkippen die Korrekturen anwenden, sind ebenfalls verschiedene Varianten denkbar, insbesondere können die Drehachsen 19' (eine oder beide Richtungen) vorteilhafterweise beim Magnetzentrum platziert werden (siehe Fig. 10). Dies hat den Vorteil, dass die HF-Spulen 2 möglichst wenig seitlich bewegt werden.

Wird der Detektor 20 nicht unmittelbar bei den HF-Spulen 2 platziert, so kann auch eine Anordnung vorteilhaft sein, bei der die Drehachse 19 durch den Detektor 20 geht (siehe Fig. 1). Somit werden bei mitbewegtem Detektor 20 durch die Korrekturbewegungen selber keine seitlichen Positionierungsfehler, die zu zusätzlichen Messfehlern führen können, auf den Detektor 20 übertragen.

Es soll noch erwähnt werden, dass die oben aufgeführten Systeme, bei denen die gleiche transversale Komponente auf den Detektor 20 wie auf die HF-Spulen 2 wirkt, grundsätzlich im Regel/Kompensations-Mode betrieben werden, d.h. es muss dann das Detektorsignal mittels Rückkopplung stets auf Null gehalten werden (siehe beispielsweise in Fig. 1).

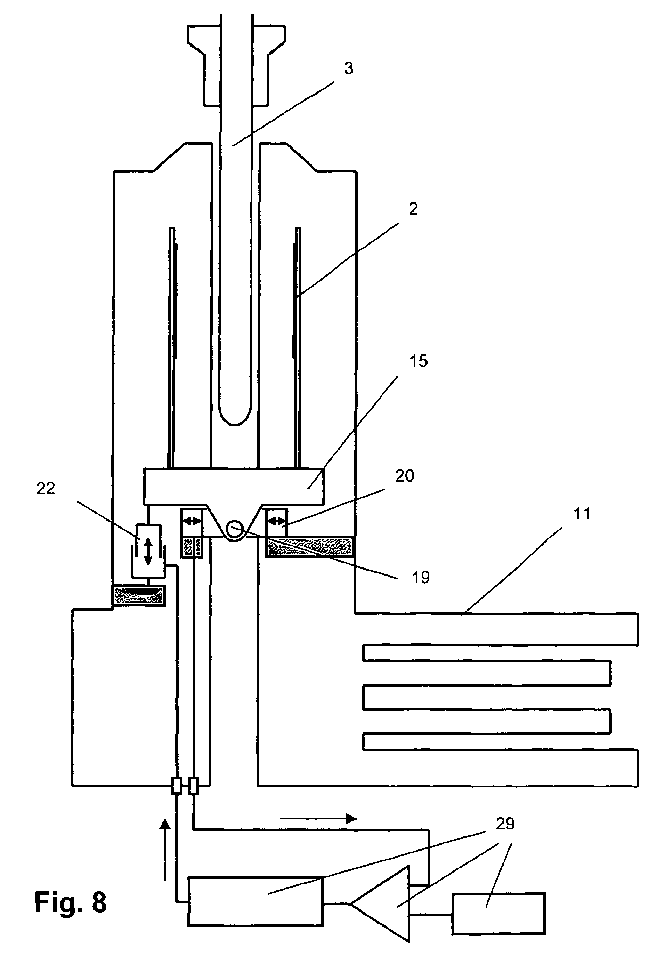

Andererseits können die Systeme so aufgebaut werden, dass der Aktuator 22 nicht auf den Detektor 20 wirkt. Dann wird der Aktuator 22 mittels des Detektorsignal so gesteuert, dass das transversale Feld, das auf die HF-Spulen 2 wirkt, konstant gehalten wird. Dies erfordert allerdings eine sehr genaue Kalibration des Systems, um eine adäquate Genauigkeit zu erreichen (äquivalentes Beispiel in Fig. 8 oder Fig.9).

Einige Aufmerksamkeit muss zwei Zusatzsystemen gewidmet werden, die sich normalerweise in einem NMR-System befinden:

### 1. Shimsystem:

In Fig. 2 ist schematisch ein Shimsystem 10 dargestellt. Es erzeugt beim Shimmen weitere, zusätzliche Feldänderungen. Diese sind jedoch i.A. sehr klein (Größenordnung der vollen Shimstärken sind typischerweise einige G/cm) und können vernachlässigt werden, insbesondere, wenn nur kleine Shimänderungen vorgenommen werden. Sie wirken sich typischerweise weder auf die HF-Spulen 2 noch auf den Detektor 20 signifikant aus. Da diese Störungen jedoch bekannt sind, können sie nötigenfalls mit in den Regelalgorithmus eingespeist werden, so dass dieser die vom Shimsystem 10 erzeugten Zusatzkomponenten automatisch mit einrechnet und falls gewünscht, wegkorrigiert.

### 2. Gradientensystem:

Bei vielen Probenköpfen ist ein Gradientensystem eingebaut, das relativ starke, geschaltete Feldgradienten erzeugt. Ein Gradientensystem 18 (dargestellt in den Figuren 9, 10, 20) erzeugt im Probenvolumen Zusatz-Magnetfelder, die lineare veränderliche B_{z} Komponenten erzeugen, mit einer Abhängigkeit von B_{z} proportional zu x, y, oder z- Richtung. Diese Gradienten werden "X, Y, bzw. Z-Gradienten" genannt. Sie erzeugen signifikante Änderungen des transversalen Feldes von der Größenordnung 01T/m (10G/cm) und mehr und können zu unerwünschten Regelaktionen des Systems führen.

Diese Regelaktionen sind insofern nicht sinnvoll, als dass die Gradienten nur kurz geschaltet werden (typischerweise z.B. 5 msec). Während dieser Zeit ist das Feld sowieso stark inhomogen, so dass eine Kompensation weder nötig noch erwünscht ist. Kompensationsversuche während dieser starken Pulse können zu Regelaktionen führen, die auch nach dem Abklingen des Pulses andauern und eine gewisse Zeit brauchen, bis die Regelung wieder zurück auf dem Ursprungszustand (entsprechend dem vor dem Gradientenpuls) ausgeregelt ist. Dies verzögert dann nur unnötig die Recovery nach dem Puls, da man unter Umständen warten muss, bis die Regelung ausgeklungen ist. Das kann durch folgende Maßnahmen überwunden werden:
i. Anbringen des Detektors axial in z-Richtung hinreichend weit außerhalb des Gradienten (Fig. 9, Detektor 20'). Die Streufelder fallen außerhalb des Gradientensystems 18 mit zunehmendem Abstand stark ab.
ii. Anbringen des Detektors radial außerhalb des Gradienten (Fig. 9, Detektor 20"). Normalerweise sind die Gradientensysteme sehr gut aktiv abgeschirmt, so dass die externen Felder vernachlässigbar klein werden.
iii. Bei X oder Y- Gradienten sind dazu noch die Bᵣ Felder auf der z = 0 Ebene aus Symmetriegründen identisch gleich Null. Eine Anordnung des Detektors auf dieser Ebene oder symmetrisch dazu erzeugt keine Signale.
iv. Bei Verwendung von z-Gradienten sind die Gradientenfelder und Streufelder rotationssymmetrisch. Darum ergeben rotationssymmetrische Anordnungen des Detektors keine Signale. Dies ist sowohl überall auf der z-Achse der Fall, wie auch bei symmetrischen Anordnungen von z.B. zwei Hallsonden oder mehr auf entgegengesetzten bzw. winkelmäßig gleichmäßig angeordneten Punkten im gleichen Abstand um die z-Achse (Fig. 13c). Dies gilt auch bei der Verwendung einer Pick-up Spule, die symmetrisch um die z-Achse angeordnet ist (Fig. 13d).
v. Der Einfluss während der Zeit wenn der Gradient aktiv ist kann aber auch rechnerisch kompensiert werden.
vi. Schließlich kann auch während der Gradientenzeit das System auf "hold" gesetzt werden, so dass Änderungen in den Inputs ignoriert und keine Korrekturen durchgeführt werden.

Insgesamt können die technischen Anforderungen, die sich aus den Feldern des Shimsystems oder von geschalteten Feldgradienten ergeben, technisch gut gelöst werden, so dass diese der Implementation der erfindungsgemäßen Stabilisierung nicht im Wege stehen.

Zur Betriebsart einer erfindungsgemäßen Vorrichtung kann noch Folgendes gesagt werden:
1. Wie oben beschrieben, kann das System zur Stabilisierung der transversalen Felder verwendet werden bei Spulen, die sich in einem entmagnetisierten Zustand befinden. Das System würde dann eingeschaltet, wenn die HF-Spulen (nach welchem Verfahren auch immer, z.B. [2]) entmagnetisiert worden sind. Dann bleiben die HF-Spulen auch weiterhin stabil und konstant unmagnetisiert, solange das System aktiv bleibt und korrekt arbeitet.
2. Dadurch werden die Feldstörungen von jeglichen supraleitenden Spulen in einem sehr niedrigen und konstanten Rahmen gehalten.
3. HF-Spulen, die von sich aus unempfindlich sind auf transversale Felder (siehe [5], [6]) werden nochmals stabiler im Betrieb, denn zusätzlich zu der geringen Empfindlichkeit auf die transversalen Felder werden eben diese Felder dazu noch gering gehalten. Somit ergibt sich eine sozusagen doppelte (quadratisch gute) Kontrolle der Störfelder und somit extrem kleine NMR Störungen am Probenort. Diese Kombination bietet die Grundlagen für unerreicht niedrige Feldstörungen, wie sie z.B. bei der Anwendung von supraleitenden NMR Spulen für extrem kleine Proben erforderlich sind.
4. Neben der Erhaltung von einmal erreichten niedrigen Störungen bietet diese Methode aber noch einen weiteren, sehr interessanten Vorteil: Wird das Stabilisierungssystem nämlich nicht erst bei kalten supraleitfähigen HF-Spulen aktiviert, sondern bereits beim Abkühlvorgang, während die Spulen noch oberhalb von T_{c} sind, und wird es auch während des SL Übergangs und beim späteren Betrieb ohne Unterbrechung aktiv gehalten, so kann dadurch verhindert werden, dass sich eine transversale Magnetisierung überhaupt erst aufbaut. Wird die SL-Schicht stets genau parallel zum homogenen Magnetfeld B₀ gehalten, kann sich schon aus Symmetriegründen keine transversale Magnetisierung aufbauen. Somit kann der SL so abgekühlt werden, dass er frei von transversaler Magnetisierung ist und die Verfahren gemäß [2], [3] werden unnötig.
5. Vorteilhafterweise weist das Kompensations-/Regelsystem weitere Signaleingänge auf. Mit diesen können bei Bedarf Korrekturinputs gegeben werden, um bekannte Störungen zu kompensieren (z.B. zusätzliche Shimmöglichkeit, sollten sich einmal doch Fehler ergeben, oder zur Korrrektur von bekannten systematischen Abweichungen beim Abkühlen. Insbesondere kann dies auch verwendet werden, um beim Abkühlen stets eine konsistent exakt parallele Ausrichtung von Dünnschicht-spulen parallel zum B₀ zu erzielen, und somit eine exakt Null transversale Magnetisierung zu erreichen).

### Referenzen zum Stand der Technik:

[1] US-A 5,619,140
[2] WO 99/24845
[3] WO 99/24821
[4] US-A 5,572,127
[5] DE 197 33 574 A1
[6] DE 101 50 131.5 (noch nicht offengelegt)
[7] US-A 5,585,723

## Patentansprüche

1. Kernspinresonanz (=NMR)-Spektrometer mit einer Magnetanordnung (1) zur Erzeugung eines homogenen statischen Magnetfeldes B₀ in Richtung einer z-Achse, sowie mit einem Hochfrequenz (=HF)-Resonator (2) zum Empfang von NMR-Signalen aus einem Messvolumen, der eine oder mehrere supraleitende Komponenten enthält,
**dadurch gekennzeichnet,**
**dass** eine Stabilisierungsvorrichtung vorgesehen ist, die auf die supraleitenden Komponenten des HF-Resonators (2) wirkende Magnetfeldkomponenten B_{T} transversal zum homogenen Magnetfeld B₀ konstant hält, dass eine Detektionsvorrichtung (20) vorgesehen ist, die die transversalen Magnetfeldkomponenten B_{T} misst, dass die Stabilisierungsvorrichtung eine aktive Kompensationsvorrichtung umfasst, der über eine Rückkopplung oder Steuerung (29) die gemessenen transversalen Magnetfeldkomponenten B_{T} zugeführt werden, und dass die aktive Kompensationsvorrichtung die transversalen Magnetfeldkomponenten im Bereich der supraleitenden Komponenten des HF-Resonators (2) konstant hält.

2. NMR-Spektrometer nach Anspruch 1, **dadurch gekennzeichnet, dass** die Stabilisierungsvorrichtung einen normalleitende und gegebenenfalls zusätzliche supraleitende Komponenten enthaltenden Transversalfeld-Schild (17) umfasst, der den HF-Resonator (2) umfänglich umgibt, mit diesem in einer bezüglich der relativen Verkippung kontrollierten Weise, insbesondere verkippungssicher starr verbunden ist und die auf den HF-Resonator (2) wirkenden transversalen Magnetfeldkomponenten B_{T} dämpft.

3. NMR-Spektrometer nach einem der vorhergehenden Ansprüche **dadurch gekennzeichnet, dass** die aktive Kompensationsvorrichtung eine Einrichtung (22) zur Durchführung einer Drehbewegung der supraleitenden Komponenten des HF-Resonators (2) um eine oder zwei nicht untereinander parallele und nicht zum homogenen Magnetfeld B₀ parallele Achsen umfasst.

4. NMR-Spektrometer nach einem der Ansprüche 1 oder 2, **dadurch gekennzeichnet, dass** die aktive Kompensationsvorrichtung eine oder mehrere Magnetfeldspulen (30) umfasst, die transversale Magnetfelder im Bereich der supraleitenden Komponenten des HF-Resonators (2) erzeugen können.

5. NMR-Spektrometer nach einem der vorhergehenden Ansprüche, **dadurch gekennzeichnet, dass** die Detektionsvorrichtung (20) zur Messung der transversalen Magnetfeldkomponenten B_{T} eine oder mehrere Hall-Sonden umfasst, und dass mindestens eine der Hall-Sonden mit einer supraleitenden Schlaufe so gekoppelt ist, dass diese die Empfindlichkeit der Hall-Sonde auf die zu messende transversale Magnetfeldkomponente steigert.

6. NMR-Spektrometer nach einem der vorhergehenden Ansprüche, **dadurch gekennzeichnet, dass** die Detektionsvorrichtung (20) zur Messung der transversalen Magnetfeldkomponenten B_{T} eine oder mehrere elektrisch leitende Pick-Up Schlaufen (24) umfasst, die periodisch verkippt und deren induzierte Spannungen ausgewertet werden.

7. NMR-Spektrometer nach Anspruch 6, **dadurch gekennzeichnet, dass** die Detektionsvorrichtung (20) eine Einrichtung zur phasensensitiven Detektion der induzierten Spannung in der (den) Pick-Up Schlaufe(n) (24) aufweist, und dass die phasensensitive Auswertung der induzierten Spannung in der Pick-Up Schlaufe (24) mit der Frequenz der Kippbewegung erfolgt.

8. NMR-Spektrometer nach einem der Ansprüche 6 oder 7, **dadurch gekennzeichnet, dass** zwei oder mehrere entgegengesetzt periodisch verkippte Pick-Up Spulen (24) so geschaltet sind, dass sich die B_{T} - Signalkomponenten addieren, und dass die entgegengesetzt verkippten Spulen so dimensioniert sind, mit solchen Kippamplituden betrieben werden und so geschaltet sind, dass sich die sich durch das homogene Magnetfeld B₀ ergebenden Signalkomponenten möglichst exakt subtrahieren.

9. NMR-Spektrometer nach einem der Ansprüche 1 bis 4, **dadurch gekennzeichnet, dass** die Detektionsvorrichtung (20) zur Messung der transversalen Magnetfeldkomponenten B_{T} ein NMR Sende/Empfangssystem umfasst, das mittels der Bestimmung einer Kernresonanzfrequenz den absoluten Betrag des Magnetfelds im Messvolumen bestimmt, und bei dem mittels supraleitender, benachbarter Strukturen transversale Feldkomponentenänderungen dB_{T} in longitudinale Feldkomponentenänderungeri dB₀ umgewandelt werden.

10. NMR-Spektrometer nach einem der vorhergehenden Ansprüche, **dadurch gekennzeichnet, dass** die Detektionsvorrichtung (20') auf der Magnetachse angeordnet oder so aus mehreren Teildetektoren um die z-Achse herum zusammengesetzt ist, dass sie effektiv die auf der z-Achse auftretenden transversalen Magnetfeldkomponenten B_{T} misst.

11. NMR-Spektrometer nach einem der Ansprüche 3 oder 10, **dadurch gekennzeichnet, dass** die Kompensationsvorrichtung einen oder mehrere Piezo-Aktuatoren (22) zur Verkippung der supraleitenden Komponenten des HF-Resonators (2) aufweist.

12. Verfahren zum Betrieb eines NMR-Spektrometers nach einem der Ansprüche 1 bis 11, **dadurch gekennzeichnet, dass** die Auswertung der gemessenen Änderungen der transversalen Magnetfeldkomponenten B_{T} unter Berücksichtigung von bekannten Einflüssen, die durch ein Shimsystem (10) erzeugt werden, erfolgt, und dass die Zusatzfelder, die durch Veränderungen der Einstellung des Shimsystems (10) erzeugt werden, bei der Korrektur mit einberechnet werden.

13. Verfahren zum Betrieb eines NMR-Spektrometers nach einem der Ansprüche 1 bis 11, **dadurch gekennzeichnet, dass** die Auswertung der gemessenen Änderungen der transversalen Magnetfeldkomponenten B_{T} unter Berücksichtigung von bekannten Einflüssen, die durch ein Gradientensystem (18) erzeugt werden, erfolgt, und dass die Zusatzfelder, die durch das Schalten von Gradienten erzeugt werden, bei der Korrektur mit berücksichtigt werden und/oder dass während der Zeit, in der der Gradient geschaltet wird, keine Korrekturen vorgenommen werden.

14. Verfahren zum Betrieb eines NMR-Spektrometers nach einem der Ansprüche 1 bis 11, **dadurch gekennzeichnet, dass** die Kompensationsvorrichtung bereits vor oder während des Abkühlens der supraleitenden Komponenten des HF-Resonators (2) aktiviert wird, und dass sie während der Kühlung unter die Sprungtemperatur T_{c} aktiviert bleibt.

15. Verfahren zum Betrieb eines NMR-Spektrometers nach einem der Ansprüche 1 bis 11, **dadurch gekennzeichnet, dass** zusätzlich zu einer aktiven Kontrolle gleichzeitig auch eine Dämpfung der hochfrequenten Transversalfeldkomponenten mit einem Transversalfeld-Schild (17) nach Anspruch 2 erfolgt.

## Claims

1. Nuclear magnetic resonance (NMR) spectrometer comprising a magnet configuration (1) for generating a homogeneous static magnetic field B₀ in the direction of a z-axis, and a radio frequency (RF) resonator (2) for receiving NMR signals from a measuring volume, which contains one or more superconducting components, **characterized in that** a stabilizing device is provided, which keeps constant the magnetic field components B_{T} that act on the superconducting components of the RF resonator (2) transversely to the homogeneous magnetic field B₀, a detection device (20) is provided, which measures the transverse magnetic field components B_{T}, the stabilizing device comprises an active compensation device to which the measured transverse magnetic field components B_{T} are supplied via a feedback or control (29), and the active compensation device keeps constant the transverse magnetic field components in the area of the superconducting components of the RF resonator (2).

2. NMR spectrometer according to claim 1, **characterized in that** the stabilizing device comprises a transverse field screen (17) that contains normally conducting and, if necessary, additional superconducting components, surrounds the periphery of the RF resonator (2), is rigidly connected thereto in a controlled fashion with respect to relative tilting, in particular, such that it cannot tilt, and damps the transverse magnetic field components B_{T} that act on the RF resonator (2).

3. NMR spectrometer according to one of the preceding claims, **characterized in that** the active compensation device comprises a means (22) for performing a rotary motion of the superconducting components of the RF resonator (2) about one or two axes which are not parallel to each other and are not parallel to the homogeneous magnetic field B₀ either.

4. NMR spectrometer according to one of the claims 1 or 2, **characterized in that** the active compensation device comprises one or more magnetic field coils (30) which can generate transverse magnetic fields in the area of the superconducting components of the RF resonator (2).

5. NMR spectrometer according to one of the preceding claims, **characterized in that** the detection device (20) for measuring the transverse magnetic field components B_{T} comprises one or more Hall probes, wherein at least one of the Hall probes is coupled to a superconducting loop in such a fashion that the latter increases the sensitivity of the Hall probe with respect to the transverse magnetic field component to be measured.

6. NMR spectrometer according to one of the preceding claims, **characterized in that** the detection device (20) for measuring the transverse magnetic field components B_{T} comprises one or more electrically conducting pick-up loops (24) which are periodically tilted and whose induced voltages are evaluated.

7. NMR spectrometer according to claim 6, **characterized in that** the detection device (20) comprises a means for phase-sensitive detection of the induced voltage in the pick-up loop(s) (24), and phase-sensitive evaluation of the induced voltage in the pick-up loop (24) is performed with the frequency of the tilting motion.

8. NMR spectrometer according to one of the claims 6 or 7, **characterized in that** two or more pick-up coils (24), which are oppositely and periodically tilted, are connected in such a manner that the B_{T} signal components add up, and the oppositely tilted coils are dimensioned, operated with tilting amplitudes and connected in such a fashion that the signal components resulting from the homogeneous magnetic field B₀ are subtracted with maximum precision.

9. NMR spectrometer according to one of the claims 1 though 4, **characterized in that** the detection device (20) for measuring the transverse magnetic field components B_{T} comprises an NMR transmitter/receiver system which determines the absolute amount of the magnetic field in the measuring volume through determination of a nuclear magnetic resonance frequency, and wherein transverse field component changes dB_{T} are converted into longitudinal field component changes dB₀ through superconducting neighboring structures.

10. NMR spectrometer according to one of the preceding claims, **characterized in that** the detection device (20') is disposed on the magnetic axis or is composed of several partial detectors around the z-axis, such that it effectively measures the transverse magnetic field components B_{T} that occur on the z-axis.

11. NMR spectrometer according to one of the claims 3 or 10, **characterized in that** the compensation device comprises one or more piezo actuators (22) for tilting the superconducting components of the RF resonator (2).

12. Method for operating an NMR spectrometer according to one of the claims 1 through 11, **characterized in that** the measured changes of the transverse magnetic field components B_{T} are evaluated by taking into consideration known influences which are generated by a shim system (10), and the additional fields which are generated by changes in the setting of the shim system (10) are taken into account in the correction.

13. Method for operating an NMR spectrometer according to one of the claims 1 through 11, **characterized in that** the measured changes of the transverse magnetic field components B_{T} are evaluated by taking into consideration known influences generated by a gradient system (18), and the additional fields which are generated by gradient switching, are taken into consideration in the correction and/or no corrections are performed during switching of the gradient.

14. Method for operating an NMR spectrometer according to one of the claims 1 through 11, **characterized in that** the compensation device is activated already before or during cooling of the superconducting components of the RF resonator (2), and remains activated during cooling below the transient temperature T_{c}.

15. Method for operating an NMR spectrometer according to one of the claims 1 through 11, **characterized in that**, in addition to active control, the radio frequency transverse field components are simultaneously also damped with a transverse field screen (17) in accordance with claim 2.

## Revendications

1. Spectromètre à résonance magnétique nucléaire (RMN) avec un dispositif magnétique (1) pour générer un champ magnétique statique homogène B₀ suivant un axe z, ainsi qu'avec un résonateur à haute fréquence (= HF) (2) pour la réception de signaux RMN en provenance d'un volume de mesure qui contient un ou plusieurs composants supraconducteurs,
**caractérisé en ce**
**qu'**il est prévu un dispositif de stabilisation qui maintient constante les composantes de champ magnétique B_{T} transversales au champ magnétique homogène B₀ agissant sur les composants supraconducteurs du résonateur HF (2), qu'il est prévu un dispositif de détection (20) qui mesure les composantes de champ magnétique transversales B_{T}, que le dispositif de stabilisation comprend un dispositif de compensation active auquel sont amenées par l'intermédiaire d'une rétroaction ou d'une commande (29) les composantes de champ magnétique transversales B_{T} mesurées, et que le dispositif de compensation active maintient constantes les composantes de champ magnétique transversales dans la région des composants supraconducteurs du résonateur HF (2).

2. Spectromètre RMN selon la revendication 1, **caractérisé en ce que** le dispositif de stabilisation comprend un écran de champ transversal (17) contenant un composant normalement conducteur et le cas échéant des composants supraconducteurs supplémentaires, qui entoure périphériquement le résonateur HF (2), est relié à celui-ci d'une manière contrôlée en ce qui concerne le basculement relatif, en particulier rigidement de manière à exclure tout basculement, et atténue au moins les composantes de champ magnétique transversales B_{T} agissant sur le résonateur HF (2).

3. Spectromètre RMN selon l'une des revendications précédentes, **caractérisé en ce que** le dispositif de compensation active comprend un dispositif (22) pour effectuer un mouvement de rotation des composants supraconducteurs du résonateur HF (2) autour d'un ou de deux axes non parallèles entre eux et non parallèles au champ magnétique homogène B₀.

4. Spectromètre RMN selon l'une des revendications 1 ou 2, **caractérisé en ce que** le dispositif de compensation active comprend une ou plusieurs bobines de champ magnétique (30) qui peuvent générer des champs magnétiques transversaux dans la région des composants supraconducteurs du résonateur HF (2).

5. Spectromètre RMN selon l'une des revendications précédentes, **caractérisé en ce que** le dispositif de détection (20) pour la mesure des composantes de champ magnétique transversales B_{T} comprend une ou plusieurs sondes à effet Hall, et qu'au moins une des sondes à effet Hall est couplée à une boucle supraconductrice de façon que celle-ci augmente la sensibilité de la sonde de Hall à la composante de champ magnétique transversale à mesurer.

6. Spectromètre RMN selon l'une des revendications précédentes, **caractérisé en ce que** le dispositif de détection (20) pour la mesure des composantes de champ magnétique transversales B_{T} comprend une ou plusieurs boucles de pick-up (24) électroconductrices qui sont périodiquement basculées et dont on évalue les tensions induites.

7. Spectromètre RMN selon la revendication 6, **caractérisé en ce que** le dispositif de détection (20) présente un dispositif pour la détection sensible à la phase de la tension induite dans la (les) boucle(s) de pick-up (24), et que l'évaluation sensible à la phase de la tension induite dans la boucle de pick-up (24) est réalisée à la fréquence de base du mouvement de basculement.

8. Spectromètre RMN selon l'une des revendications 6 ou 7, **caractérisé en ce que** deux ou plusieurs bobines de pick-up (24) périodiquement basculées en opposition sont couplées de façon que les composantes de signal B_{T} s'additionnent, et que les bobines basculées en opposition sont dimensionnées, actionnées avec de telles amplitudes de basculement et couplées de façon que les composantes de signal résultant du champ magnétique homogène B₀ se soustraient le plus exactement possible.

9. Spectromètre RMN selon l'une des revendications 1 à 4, **caractérisé en ce que** le dispositif de détection (20) pour la mesure des composantes de champ magnétique transversales B_{T} comprend un système d'émission/réception RMN qui, au moyen de la détermination d'une fréquence de résonance magnétique nucléaire, détermine la valeur absolue du champ magnétique dans le volume de mesure, et dans lequel, au moyen de structure supraconductrices voisines, des variations de composantes de champ transversales dB_{T} sont converties en variations de composantes de champ longitudinales dB₀.

10. Spectromètre RMN selon l'une des revendications précédentes, **caractérisé en ce que** le dispositif de détection (20') est disposé sur l'axe magnétique ou composé de plusieurs détecteurs partiels autour de l'axe z de façon qu'il mesure effectivement les composantes de champ magnétique transversales B_{T} qui apparaissent sur l'axe z.

11. Spectromètre RMN selon l'une des revendications 3 ou 10, **caractérisé en ce que** le dispositif de compensation présente un ou plusieurs actionneurs piézoélectriques (22) pour basculer les composants supraconducteurs du résonateur HF (2).

12. Procédé pour faire fonctionner un spectromètre RMN selon l'une des revendications 1 à 11, **caractérisé en ce que** l'évaluation des variations mesurées des composantes de champ magnétique transversales B_{T} s'effectue en tenant compte d'influences connues qui sont générées par un système de compensation (10), et que les champs supplémentaires qui sont générés par des modifications du réglage du système de compensation (10) sont prises en compte dans le calcul lors de la correction.

13. Procédé pour faire fonctionner un spectromètre RMN selon l'une des revendications 1 à 11, **caractérisé en ce que** l'évaluation des variations mesurées des composantes de champ magnétique transversales B_{T} s'effectue en tenant compte d'influences connues qui sont générées par un système de gradients (18), et que les champs supplémentaires qui sont générés par le couplage de gradients sont pris en compte lors de la correction et/ou qu'aucune correction n'est effectuée pendant le temps pendant lequel le gradient est couplé.

14. Procédé pour faire fonctionner un spectromètre RMN selon l'une des revendications 1 à 11, **caractérisé en ce que** le dispositif de compensation est activé déjà avant ou pendant le refroidissement des composants supraconducteurs du résonateur HF (2), et qu'il reste activé pendant le refroidissement sous la température de transition T_{c}.

15. Procédé pour faire fonctionner un spectromètre RMN selon l'une des revendications 1 à 11, **caractérisé en ce qu'**en plus d'un contrôle actif, on effectue en même temps aussi une atténuation des composantes de champ transversales à haute fréquence avec un écran de champ transversal (17) selon la revendication 2.
